# EUROPÄISCHE PATENTSCHRIFT

(11) **EP 1 543 452 B1**
(45) Veröffentlichungstag und Bekanntmachung des Hinweises auf die Patenterteilung: **09.01.2008**
(21) Anmeldenummer: 03770888.0
(22) Anmeldetag: 26.09.2003
(51) Int. Cl.: G06F 17/50

(54) **VERFAHREN ZUM BESTIMMEN DER ANORDNUNG VON KONTAKTFLÄCHEN AUF DER AKTIVEN OBERSEITE EINES HALBLEITERCHIPS**
METHOD FOR DETERMINING THE POSITIONING OF CONTACT SURFACES ON THE ACTIVE UPPER FACE OF A SEMICONDUCTOR CHIP
PROCEDE DE DETERMINATION DE LA DISPOSITION DE SURFACES DE CONTACT SUR LA FACE SUPERIEURE ACTIVE D'UNE PUCE A SEMI-CONDUCTEUR

(30) Priorität: 27.09.2002 DE 10245452
(43) Veröffentlichungstag der Anmeldung: 22.06.2005
(73) Patentinhaber: Infineon Technologies AG, 81669 München (DE)
(72) Erfinder: GLIESE, Dagmar, 80469 München (DE); EINSPENNER, Jürgen, 81241 München (DE); ZIEBELL, Herbert-Arndt, 93087 Alteglofsheim (DE)
(74) Vertreter: Schäfer, Horst
(86) Internationale Anmeldenummer: PCT/DE2003/003208
(87) Internationale Veröffentlichungsnummer: WO 2004/031996

(56) Entgegenhaltungen:
- US-A- 5 331 572
- US-A- 5 498 767
- US-A- 5 608 638
- US-B1- 6 357 036
- US-B1- 6 405 357

## Beschreibung

Die Erfindung betrifft ein Verfahren zum Bestimmen der Anordnung von Kontaktflächen auf der aktiven Oberseite eines Halbleiterchips.

In der vorliegenden Erfindung werden elektronische Bauteile mit Halbleiterchips betrachtet, die in oder auf Gehäusen angeordnet sind. Bei einem solchen Gehäuse kann es sich um ein beliebiges Gehäuse aus Kunststoff oder aus Plastik, um eine Leiterplatte oder um einen lead frame bzw. eine Flachleiterrahmen handeln. Bei der Herstellung eines solchen elektronischen Bauteils wird der Halbleiterchip elektrisch durch Bonddrähte mit dem Gehäuse verbunden. Diese Bonddrähte erstrecken sich von Kontaktflächen bzw. chippads, die auf der aktiven Oberseite der Halbleiterchips angeordnet sind, zu den Kontaktanschlußflächen, die sich auf der Oberseite der Gehäuses, vorzugsweise an wenigstens einem dem Halbleiterchip zugewandten Innenrand befinden.

Vor der eigentlichen Fertigung solcher oft sehr komplexer elektronischer Bauteile steht ein Entwurfsprozeß, in dem die genauen geometrischen und elektrischen Spezifikationen des elektronischen Bauteils mit Halbleiterchip und mit Gehäuse als Basis für den Produktionsprozeß festgelegt werden.

Die bisher üblichen Entwurfsprozesse, insbesondere für derartige Halbleiterchips, liefern in der Praxis oft fehlerhafte Designs, die erst in einem nachgelagerten Simulationsschritt erkannt werden können und manchmal sogar unentdeckt bleiben. Die Behebung solcher Probleme verursacht eine enorme Verzögerung der Herstellung des Halbleiterchips und ist mit großen Kosten verbunden.

Die US 6,405,357 B1 zeigt ein Verfahren zum Positionieren von Bondpads auf einem Halbleiterchip, bei dem der Abstand zwischen benachbarten Bondpads in Abhängigkeit von den geschätzten Abständen der Bondwires variiert wird. In der US 6,357,036 B1 wird ein verfahren angegeben, bei dem mit Hilfe eines Computers ein Wirebondingdiagramm generiert wird und bei Verletzungen von Designrules die Position der Pads verändert wird. Die US 5,331,572 zeigt ein Layoutsystem für ein IC, bei dem makroblöcke mit normaler Funktionalität in den inneren Bereichen des ICs und Eingangs-/Ausgangsblöcke in den äußeren Bereichen des ICs untergebracht sind. In der US 5,498,767 werden Bondpads im äußeren Bereich eines Halbleiterchips so positioniert, dass der Abstand zwischen den Mittelpunkten der Bondpads sich in Richtung der Chipecken vergrößert.

Das Computersystem der US 5,608,638 stellt eine Benutzeroberfläche zum automatischen Generieren von Drahtverbindungen zwischen Chippads und Bondfingern bereit. Eine radiale Anordnung der Bonddrähte sowie eine Anordnung der Kontaktflächen, bei der die Bonddrähte möglichst kurz sind, wird in der US 5,828,116 dargestellt.

Es ist daher Aufgabe der Erfindung, ein Verfahren anzugeben, das einen fehlerfreien Entwurf des elektronischen Bauteils, des Halbleiterchips und des Gehäuses liefert, der als Grundlage für den nachfolgenden Fertigungsprozeß dienen kann. Insbesondere soll durch das Entwurfsverfahren ein fehlerfreier Bondplan erstellt werden.

Es ist eine weitere Aufgabe der Erfindung, ein Verfahren anzugeben, mit dem die Entwicklung von Halbleiterchips und von Gehäusen besser aufeinander abgestimmt werden kann.

Diese Aufgabe wird durch den Gegenstand der unabhängigen Ansprüche gelöst. Vorteilhafte Ausgestaltungen ergeben sich aus den jeweiligen Unteransprüchen.

Ein erfindungsgemäßes elektronisches Bauteil umfaßt ein Gehäuse sowie einen Halbleiterchip, der mit seiner passiven Rückseite auf der Oberseite des Gehäuses bzw. in einer Fläche innerhalb des Gehäuses angeordnet ist. Innerhalb des Gehäuses befinden sich Kontaktanschlußflächen, die neben dem Halbleiterchip und/oder um den Halbleiterchip herum angeordnet sind. Falls das Gehäuse eine Ausnehmung hat, so sind diese Kontaktanschlußflächen vorzugsweise an einem inneren Rand der Oberseite des Gehäuses angeordnet, der die Kontur der Ausnehmung festlegt. Der Halbleiterchip weist auf seiner aktiven Oberseite in Randbereichen Kontaktflächen auf. Diese befinden sich jeweils auf gerade ausgebildeten gedachten Verbindungslinien zwischen den Kontaktanschlußflächen und dem Flächenschwerpunkt bzw. dem Mittelpunkt der aktiven Oberseite des Halbleiterchips. Zwischen den Kontaktflächen und den Kontaktanschlußflächen verlaufen Bonddrähte. Ein derartiges elektronisches Bauteil kann zusätzlich mit einer Gußmasse vergossen sein.

Eine derartige Anordnung der Kontaktflächen bietet den Vorteil, daß die Fertigungsabläufe der Bondmaschinen optimiert werden können. Die Bonddrähte weisen darüber hinaus einen radialen Verlauf auf und können hohen Belastungen bzw. großem stress widerstehen.

Die Erfindung betrifft weiterhin ein Verfahren zum Bestimmen der Anordnung von Kontaktflächen auf der aktiven Oberseite eines Halbleiterchips.

Bei diesem Verfahren werden zunächst Halbleiterchipdaten in das Computersystem bzw. in einen Arbeitsspeicherbereich des Computersystems eingelesen, die geometrische Eigenschaften des Halbleiterchips sowie Informationen über die Anzahl der an den Rändern des Halbleiterchips anzuordnenden Kontaktflächen aufweisen. Diese Daten können beispielsweise in Form einer Netzliste vorliegen, welche die Reihenfolge der Kontaktflächen angibt. Dann werden Kontaktflächendaten in das Computersystem eingelesen, welche die geometrischen und/oder elektrischen Eigenschaften der auf der aktiven Oberseite des Halbleiterchips anzuordnenden Kontaktflächen aufweisen. Die genaue Anordnung dieser Kontaktflächen auf der aktiven Oberseite des Halbleiterchips ist zu diesem Zeitpunkt des Verfahrens noch nicht bekannt. Bei diesen Kontaktflächendaten handelt es sich insbesondere um die Form bzw. um die Länge und die Breite der Kontaktflächen sowie um einen um die Kontaktflächen einzuhaltenden Mindestabstand. Beispielsweise zwischen Signalkontaktflächen und Spannungsversorgungskontaktflächen oder zwischen analogen und digitalen Kontaktflächen können bestimmte Mindestabstände vorgeschrieben sein. Anschließend werden die Gehäusedaten eingelesen, welche die Gehäusespezifika berücksichtigen. Dabei handelt es sich um die geometrischen und/oder die elektrischen Eigenschaften des Gehäuses, in dem der Halbleiterchip plaziert werden soll, um die geometrischen und/oder elektrischen Eigenschaften und um die exakte Plazierung derjenigen Kontaktanschlußflächen, die auf der Oberseite des Gehäuses angeordnet sind und die mit den Kontaktflächen des Halbleiterchips zu verbinden sind. Diese Gehäusedaten können beispielsweise in GDSII- bzw. "Graphical Data Standard Interface"-Format vorliegen und genügen bestimmten Anforderungen bzw. enthalten bestimmte vorgegebene Objekte. Nun werden Fertigungsdaten in das Computersystem eingelesen, welche unter anderem die Anordnung des Halbleiterchip in bezug zu dem Gehäuse festlegen. Diese Fertigungsdaten ergeben sich aus den Design-Regeln.

Sämtliche in das Computersystem eingelesene Daten bilden die Eingangsdaten für das erfindungsgemäße Verfahren und sind vorteilhafterweise in Datenbanken bzw. Bibliotheken des Computersystems gespeichert. Auf diese Eingangsdaten greift das erfindungsgemäße Verfahren zurück. Die Reihenfolge der einzelnen vorgehend beschriebenen Einleseschritte ist dabei beliebig.

Basierend auf sämtlichen zuvor eingelesenen Daten wird von dem Computersystem nun ein Abbild des elektronischen Bauteils erzeugt, welches das Gehäuse und den mit seiner passiven Rückseite auf der Oberseite des Gehäuses bzw. in einer Fläche innerhalb des Gehäuses angeordneten Halbleiterchip darstellt.

Dieses Abbild liegt in Form einer Graphik vor, hinter der geometrische und/oder elektrische Daten insbesondere in binärer Form hinterlegt sind. Die Struktur eines solchen Abbilds ist dem Fachmann bekannt und braucht hier nicht näher erläutert zu werden.

Im nächsten Verfahrensschritt wird die genaue Anordnung der Kontaktflächen auf der aktiven Oberseite des Halbleiterchips in deren Randbereichen bestimmt. Diese Anordnungsbestimmung wird ausschließlich in dem Abbild des elektronischen Bauteils auf dem Computersystem vorgenommen. Dabei umfaßt die Erfindung die nachfolgend erläuterten vier Verfahrensvarianten.

Gemäß einer ersten Verfahrensvariante werden die Kontaktflächen so angeordnet, daß sie jeweils auf geraden Verbindungslinien bzw. Hilfslinien zwischen den Kontaktanschlußflächen auf der Oberseite des Gehäuses und dem Flächenschwerpunkt bzw. Mittelpunkt der aktiven Oberseite des Halbleiterchips liegen. Dadurch ergibt sich ein radialer Verlauf der aufzubringenden Bonddrähte. Die aufzubringenden Bonddrähte sind bei einer derartigen Anordnung der Kontaktflächen und der Kontaktanschlußflächen besonders belastungs- und stressoptimiert.

Gemäß einer weiteren Verfahrensvariante werden die Kontaktflächen zunächst jeweils auf geraden Verbindungslinien zwischen den Kontaktanschlußflächen auf der Oberseite des Gehäuses und dem Flächenschwerpunkt bzw. Mittelpunkt der aktiven Oberseite des Halbleiterchips angeordnet. Danach werden die jeweils an einem gleichen Halbleiterchiprand angeordneten Kontaktflächen derart verschoben, daß die Abstände zwischen benachbarten Kontaktflächen und/oder zwischen den jeweils äußersten Kontaktflächen pro Halbleiterchiprand und den angrenzenden Halbleiterchiprändern jeweils gleich groß ausgebildet sind. Bei dieser Verfahrensvariante werden vorteilhafterweise zunächst alle Kontaktflächen an demjenigen Halbleiterchiprand angeordnet, durch den die Verbindungslinie zwischen der zugehörigen Kontaktanschlußfläche und dem Flächenschwerpunkt bzw. dem Mittelpunkt der aktiven Oberseite des Halbleiterchips verläuft. Eine nachteilige Anordnung von Kontaktflächen auf einem von der Kontaktanschlußfläche weiter entfernteren Halbleiterchiprand wird so zuverlässig vermieden. Erst danach werden die Kontaktanschlußflächen auf dem jeweiligen Halbleiterchiprand gleichverteilt, wodurch eine günstige Verteilung der Kontaktflächen auf den Halbleiterchiprändern sichergestellt wird.

Gemäß einer letzten Verfahrensvariante werden die Kontaktflächen so angeordnet, daß die Abstände zwischen den jeweils miteinander elektrisch zu verbindenden Kontaktflächen und Kontaktanschlußflächen minimiert werden. Bei dieser Verfahrensvariante wird eine besonders drahtlängenoptimale Bondverbindung zwischen Kontaktflächen und Kontaktanschlußflächen gewährleistet, die besonders zuverlässig und widerstandsfähig ausgebildet ist.

Das erfindungsgemäße Verfahren liefert somit einen Vorschlag für eine Kontaktflächenanordnung auf der aktiven Oberseite des Halbleiterchips. Die so bestimmte Anordnung wird in einem Speicherbereich des Computersystems in Form von auf einen Nullpunkt bezogenen geometrischen Daten abgespeichert. Es ist auch möglich, die derart bestimmten Anordnungsdaten direkt dem Herstellungsprozeß des Halbleiterchips und/oder des Gehäuses und/oder des elektronischen Bauteils zur Verfügung zu stellen. Diese Anordnungsdaten können auch für nachfolgende Entwurfsprozesse des Halbleiterchips und/oder des Gehäuses und/oder des elektronischen Bauteils genutzt werden. Dabei können Schnittstellen zu anderen computerimplementierten Verfahren vorgesehen sein, beispielsweise zu sogenannten "floor plannern" und "design tools".

Gemäß einem Grundgedanken der Erfindung wird im Unterschied zu gängigen Verfahren die Plazierung der Kontaktflächen auf dem Halbleiterchip nicht mehr durch Verwendung manuell entworfener Verbindungslisten, bei deren Erstellung die Erfahrung der Designer einfließt, sondern mit einem Computersystem bestimmt, das auf bestehende Datenbanken zugreift und Algorithmen verwendet. Somit basiert das erfindungsgemäße Verfahren nicht auf groben Abschätzungen, sondern berücksichtigt automatisch technologiebedingte Parameter, die sich bspw. aus Kontaktflächenbibliotheken ergeben und die einen Einfluß auf die Kontaktflächenanordnung auf der aktiven Oberseite der Halbleiterchips sowie auf die Anzahl der zur Strom- bzw. Spannungsversorgung vorgesehenen Kontaktflächen haben.

Gemäß einem zweiten Grundgedanken der Erfindung kann der Benutzer unter mehreren zuverlässigen Kriterien zur optimierten Anordnung der Kontaktflächen auswählen. Eine fehlerhafte oder nur suboptimale Anordnung der Kontaktflächen auf dem Halbleiterchip wird so zuverlässig vermieden. Besonders bei Halbleiterchips mit einer Vielzahl von Kontaktflächen, sogenannten "high pin count devices", ergibt sich durch das erfindungsgemäße Verfahren eine deutliche Senkung der Fehleranfälligkeit bzw. der Fehlerrate.

Gemäß einem weiteren Grundgedanken der Erfindung wird die Abhängigkeit der Anordnung der Kontaktflächen auf dem Halbleiterchip von den geometrischen und elektrischen Eigenschaften des Gehäuses bereits während des Entwurfsprozesses berücksichtigt. Dadurch wird sichergestellt, daß der entworfene Halbleiterchip auch wirklich in dem geplanten Gehäuse plaziert werden kann und das elektronisches Bauteil auch wirklich herstellbar ist. Dies ist besonders wichtig, da in der Praxis die Entwicklung der Halbleiterchips und der Gehäuse häufig getrennt voneinander erfolgen und sich daraus viele Fehlerquellen ergeben.

Die Anzahl der besonders fehleranfälligen manuellen Arbeitsschritte wird bei dem erfindungsgemäßen Verfahren deutlich reduziert. Des weiteren wird der Entwurfsprozeß bzw. der "design flow" von erfindungsgemäßen elektronischen Bauteilen durch die Verwendung des erfindungsgemäßen Verfahrens zum Bestimmen der Anordnung von Kontaktflächen vereinheitlicht.

Darüber hinaus können die von dem erfindungsgemäßen Verfahren erzeugten Kontaktflächenanordnungsdaten in einem Standardausgabeformat, beispielsweise "DEF" zur Verfügung gestellt werden. Dieses Format kann vorteilhafterweise von einer Vielzahl von computerimplementierten weiterführenden Entwurfsverfahren, insbesondere von "floor planning tools" gelesen werden und dient als Standardschnittstelle. Dadurch können sämtliche erzeugte Kontaktflächenanordnungsdaten von weiterführenden computerimplementierten Entwurfsverfahren direkt weiterverarbeitet werden. Das erfindungsgemäße Verfahren ist demnach vielseitig und benutzerfreundlich einsetzbar. Des weiteren kann das erfindungsgemäße Verfahren auch auf Ausgabedaten derjenigen computerimplementierten Entwurfsverfahren zugreifen, welche diese Standardschnittstelle verwenden.

Die Erfindung sieht weiterhin ein Verfahren zum Erstellen eines Bondplanes für ein elektronisches Bauteil mit einem Halbleiterchip und mit einem Gehäuse vor. Dieses Verfahren baut auf dem vorstehend beschriebenen Verfahren zur Anordnung von Kontaktflächen auf und wird ebenfalls auf einem Computersystem ausgeführt.

Zu Beginn des Verfahrens zum Erstellen eines Bondplanes wird die Anordnung von Kontaktflächen auf der aktiven Oberseite des Halbleiterchips durch Ausführen des vorgehend beschriebenen Verfahrens bestimmt. Dann wird die Anordnung von integrierten Schaltungen, insbesondere von Speicherelementen, von Speicherinterfaces, von Prozessoren bzw. CPUs und von Analogbausteinen auf der aktiven Oberseite des Halbleiterchips festgelegt. Die endgültige Größe und Ausführung der einzelnen auf dem Halbleiterchip anzuordnenden integrierten Schaltungen sind dabei noch nicht bekannt. Bei diesem Verfahrensschritt steht nur fest, welche integrierte Schaltungen auf dem Halbleiterchip plaziert werden sollen. Dies ergibt sich aus den zu Beginn eingelesenen Halbleiterchipdaten. Die Anordnung der integrierten Schaltungen erfolgt dabei basierend auf ihren geschätzten Dimensionen unter Verwendung von dem Fachmann bekannten Anordnungsverfahren. Des weiteren wird die Anordnung von als Metallflächen auf dem Halbleiterchip ausgebildeten Füllstrukturen auf der aktiven Oberseite des Halbleiterchips bestimmt. Diese Füllstrukturen sind zur elektrischen Verbindung bzw. zur Spannungsversorgung der Kontaktflächen vorgesehen und befinden sich an den Rändern des Halbleiterchips jeweils zwischen den Kontaktflächen. Diese auch als "filler"-Zellen bezeichneten Füllstrukturen sind in ihrer Größe bereits vorher festgelegt und ergeben sich aus den zu Beginn des Verfahrens eingelesenen Fertigungsdaten. Die Planung der Anordnung der integrierten Schaltungen und der Füllstrukturen wird auch als "floor planning" bezeichnet. Die Anordnung der integrierten Schaltungen hängt von der Anordnung der Kontaktflächen auf dem Halbleiterchip ab. Daher ist es möglich, daß in diesem Verfahrensschritt die Anordnung der Kontaktflächen auf den Randbereichen des Halbleiterchips geändert wird.

Im nun folgenden Verfahrensschritt wird ein Abbild bzw. ein physikalisches Layout der aktiven Oberseite des Halbleiterchips auf Gatterebene bestimmt. Dabei werden die Halbleiterbauelemente der zuvor bestimmten integrierten Schaltungen in dem Abbild auf Gatterebene definiert, plaziert und verdrahtet. Die Halbleiterbauelemente gliedern sich in aktive Bauelemente, z.B. Transistoren, Dioden, Thyristoren und Triax und in passive Bauelemente z.B. Widerstände, Induktivitäten, Kapazitäten und Filter. Das so bestimmte Abbild auf Gatterebene umfaßt auch die Kontaktflächen des Halbleiterchips und weist mehrere übereinander und nebeneinander angeordnete Ebenen bzw. Materialschichten auf. Es liegt in binärer Form vor und kann in ein Textformat umgewandelt werden.

Der darauffolgende Verfahrensschritt sieht das Überprüfen des elektrischen und des logischen Verhaltens des Halbleiterchips unter Verwendung von gängigen computerimplementierten und dem Fachmann bekannten Simulations- und Verifikationsverfahren vor, beispielsweise durch Analogsimulatoren oder Verzögerungszeitberechnungen bzw. "delay calculations". Bei diesen Simulations- und Verifikationsverfahren werden elektrische Signale durch den Halbleiterchip geschickt und die gemessenen Ausgangsgrößen mit erwarteten verglichen. In diesem Verfahrensschritt werden Fehler in dem Abbild des Halbleiterchips zuverlässig detektiert. Ferner ist es an dieser Stelle möglich, beispielsweise durch eine Betrachtung der Signallaufzeiten, eine Aussage darüber zu treffen, ob der Halbleiterchip zu dem betrachteten Gehäuse paßt oder ob geeignetere Gehäuse vorhanden sind. Wenn an dieser Stelle Fehler in dem Abbild detektiert werden, so bricht das erfindungsgemäße Verfahren ab. Ist dies nicht der Fall, so fährt das erfindungsgemäße Verfahren mit dem Schritt des Extrahierens der für den Bondplan erforderlichen Daten aus dem zuvor bestimmten Abbild fort.

Bei diesen extrahierten Daten handelt es sich um Daten bezüglich der Anordnung und bezüglich der geometrischen und elektrischen Eigenschaften der Kontaktflächen und der Kontaktanschlußflächen. Dabei werden nur die relevanten Ebenen bzw. Materialschichten der aktiven Oberseite des Halbleiterchips betrachtet. Dabei werden vorteilhafterweise die Namen der Kontaktflächen und der Kontaktanschlußflächen mit extrahiert. Dieser Extraktionsschritt erfolgt in der Praxis mittels computerimplementierter, dem Fachmann bekannten Manipulationsverfahren, die dem "graphical data standard" bzw. "GDS" genügen.

Im nächsten Verfahrensschritt werden Gehäusedaten eingelesen, die durch einen parallelen Gehäuseentwurfsprozeß erstellt worden sind. Solch ein dem Fachmann bekannter Gehäuseentwurfsprozeß basiert dabei auf Gehäusedaten, welche die geometrischen und/oder die elektrischen Eigenschaften des Gehäuses sowie die geometrischen und/oder elektrischen Eigenschaften und die exakte Plazierung der Kontaktanschlußflächen aufweisen. Der Gehäuseentwurfsprozeß sieht dabei die Verfahrensschritte des Gehäuseentwurfs, einer Simulation, einer Kontaktvorlagenerstellung und einer Abspeicherung der Gehäusedaten in einem standardisierten Graphikformat, insbesondere in GDSII, vor. Die derart erstellten und abgespeicherten Gehäusedaten fließen bei der Erstellung eines Bondplanes ein.

Der nächste Verfahrensschritt sieht das Erstellen eines Bondplanes bzw. eines Bonddiagramms auf dem Computersystem vor.
Bei einem solchen Bondplan handelt es sich um eine abstrakte graphische Darstellung des Gehäuses und des in bzw. auf dem Gehäuse angeordneten Halbleiterchips sowie der Bondverbindungen zwischen den Kontaktflächen und den Kontaktanschlußflächen, wobei hinter dieser graphischen Darstellung die auf einen festen Nullpunkt bezogenen geometrischen und relevanten elektrischen Daten hinterlegt sind. Zum Erstellen dieses Bondplanes werden die zuvor extrahierten Daten sowie die zuvor eingelesenen Gehäusedaten verwendet.

Im nun folgenden Verfahrensschritt wird der so erstellte Bondplan auf Veränderungen gegenüber dem zu Beginn des Verfahrens erzeugten Abbild des elektronischen Bauteils überprüft und verifiziert. Dabei wird überprüft, ob sich die Anordnung der Kontaktflächen im Bondplan gegenüber der Anordnung der Kontaktflächen im zu Beginn des Verfahrens erzeugten Abbilds des elektronischen Bauteils geändert hat. Insbesondere werden Fehlermeldungen erzeugt, wenn Kontaktflächen gelöscht wurden, addiert wurden oder in der Reihenfolge vertauscht wurden. Falls in diesem Verfahrensschritt Abweichungen festgestellt werden, so kann der erstellte Bondplan verworfen und basierend auf den daraus gezogenen Erkenntnissen durch ein verbesserter Bondplan die erneute Ausführung des erfindungsgemäßen Verfahrens erstellt werden. Ergeben sich an dieser Stelle keine gravierenden Abweichungen, so wird der Bondplan in einem abschließenden Verfahrensschritt für die Bonding-Maschinen bzw. Wirebonder bereitgestellt, die den Bondplan direkt verarbeiten können. Nach der Einstellung bestimmter produktionsbedingter Prozeßparameter können die Bonding-Maschinen direkt mit der Produktion beginnen.

Gemäß einem Grundgedanken dieses Verfahrens wird der Bondplan nicht mehr manuell erstellt, sondern durch Verwendung von aus dem zuvor bestimmten Abbild extrahierten Halbleiterchipdaten, von eingelesenen Gehäusedaten sowie von zuvor bestimmten Kontaktflächenanordnungsdaten erstellt. Dabei werden vorteilhafterweise Signal- und Instanznamen mit extrahiert.

Ein weiterer Vorteil des erfindungsgemäßen Verfahrens zum Erstellen eines Bondplanes besteht darin, daß die erstellten Bondpläne bereits einer Prüfung bzw. einer Verifikation unterzogen wurden und dementsprechend eine sehr geringe Fehlerquote aufweisen. Vorhandene Fehler in den Entwurfsdaten werden zuverlässig entdeckt.

Die Erfindung betrifft auch ein Verfahren zum Erzeugen von Geometriedaten für die Erstellung von Photomasken für die Belichtung eines elektronischen Bauteils mit einem Halbleiterchip und mit einem Gehäuse mittels photolithographischer Verfahren. Das Verfahren zum Erzeugen von Geometriedaten läuft dabei ebenfalls auf einem Computersystem ab und stimmt in den ersten vier Verfahrensschritten, also bis zu dem Verfahrensschritt des Überprüfens des elektrischen und des logischen Verhaltens des Halbleiterchips mit dem bereits erläuterten erfindungsgemäßen Verfahren zum Erstellen eines Bondplanes überein. Diese Verfahrensschritte werden deshalb nicht noch einmal erläutert.

Im dem ersten vom bereits beschriebenen Verfahren differierenden Verfahrensschritt werden die für die Photomasken erforderlichen Geometriedaten aus dem zuvor bestimmten Abbild der aktiven Oberseite des Halbleiterchips unter Einberechnung von Produktionstoleranzen bestimmt. Mehrere bzw. alle zu erzeugenden Photomasken bilden dabei einen Maskensatz. Dabei kommen dem Fachmann bekannte GDS-Manipulationsroutinen zum Einsatz. Aus diesen Maskendaten für die Wafererstellung kann schließlich der Maskensatz erstellt werden, der mittels photolithographischer Prozesse auf dem Wafer abgebildet wird. Der Datenumfang der für die Photomaske erforderlichen Geometriedaten beträgt bis zu einige Hundert Gigabyte. Dementsprechend beschränkt sich die Darstellung dieser Maskendaten auf reine Geometriedaten. Eine graphische Darstellung ist kaum möglich.

Im nächsten Verfahrensschritt werden die so erzeugten Geometriedaten auf Veränderungen gegenüber dem im ersten Schritt des erfindungsgemäßen Verfahrens erzeugten Abbild des elektronischen Bauteils überprüft, insbesondere auf Verschiebungen, auf Löschungen, auf Zusammenfassungen und auf Vertauschungen der Kontaktflächen. Werden solche Abweichungen festgestellt, so erfolgt die Ausgabe einer Fehlermeldung.

Die so erzeugten Geometriedaten werden für die nachfolgenden Verfahren zur Erstellung der Photomasken bereitgestellt. Diese Geometriedaten können dabei auf einem Speicherbereich des Computersystems zwischengespeichert oder direkt weitergeleitet werden.

Ein besonderer Vorteil dieses erfindungsgemäßen Verfahrens zum Erzeugen von Geometriedaten für die Erstellung von Photomasken besteht darin, daß die für die Photomasken erforderlichen Geometriedaten ohne einen von einem Benutzer durchzuführenden Zwischenschritt automatisch erzeugt werden. Die so erzeugten Geometriedaten sind sehr präzise und weisen wenige Fehler auf.

Des weiteren kann dieses Verfahren durch die Verwendung einer Standardschnittstelle besonders benutzerfreundlich und besonders vielseitig eingesetzt werden, indem die nachfolgenden Entwurfsprogramme direkt auf die von dem erfindungsgemäßen Verfahren erzeugten Ausgabedaten zugreifen können.

Die Erfindung betrifft auch einen Halbleiterchip sowie ein elektronisches Bauteil mit einem Gehäuse und mit einem in bzw. auf dem Gehäuse angeordneten Halbleiterchip, bei deren Herstellung jeweils das erfindungsgemäße Verfahren zum Bestimmen der Anordnung von Kontaktflächen und/oder das erfindungsgemäße Verfahren zum Erstellen eines Bondplanes und/oder das erfindungsgemäße Verfahren zum Erzeugen von Geometriedaten für die Erstellung von Photomasken zum Einsatz gekommen ist. Solche Halbleiterchip bzw. solche elektronische Bauteile sind effektiv hergestellt worden und daher besonders kostengünstig. Weiterhin weisen sie eine sehr geringe Fehlerrate auf.

Die Erfindung betrifft auch ein Gehäuse, zu dessen Entwurf das erfindungsgemäße Verfahren zum Bestimmen der Anordnung von Kontaktflächen auf der aktiven Oberseite des Halbleiterchips durchgeführt worden ist und bei dem die durch dieses Verfahren erstellten Kontaktflächenanordnungsdaten als Grundlage für die Gehäuseerstellung verwendet worden sind.

Bei dem Entwurf eines solchen Gehäuses werden nach dem Gehäuseentwurf die Verfahrensschritte einer Simulation, einer Kontaktvorlagenerstellung und einer Abspeicherung der Gehäusedaten in einem standardisierten Graphikformat, insbesondere in "GDSII", ausgeführt. Die derart erstellten und abgespeicherten Gehäusedaten fließen bei der Erstellung eines Bondplanes ein. Dadurch wird sichergestellt, daß zwischen den Entwicklungsprozessen des Halbleiterchips und des Gehäuses eine Abstimmung erfolgt. Insbesondere sind die Schnittstellen zur Übergabe der Daten von dem computerimplementierten erfindungsgemäßen Verfahren zum Bestimmen der Anordnung von Kontaktflächen zu der Gehäuseentwurfsplanung, sowie zwischen der Gehäuseentwurfsplanung und dem computerimplementierten erfindungsgemäßen Verfahren zur Erstellung eines Bondplanes standardisiert. In der Praxis erfolgt bei der Übergabe der Kontaktflächenanordnungsdaten an die Gehäuseentwicklung eine Konvertierung in Netzlisten für die zur Interaktion zwischen dem Halbleiterchip und dem Gehäuse erforderlichen Gehäusedaten. Ein erfindungsgemäß entworfenes Gehäuse ist demnach auf den in ihm anzuordnenden Halbleiterchip abgestimmt, wodurch sich Schwierigkeiten bzw. Fehler bei der Kontaktierung weitgehend ausschließen lassen.

Die Erfindung ist auch in einem Computerprogramm zum Ausführen des erfindungsgemäßen Verfahrens zum Bestimmen der Anordnung von Kontaktflächen auf der aktiven Oberseite eines Halbleiterchips und/oder zum Ausführen eines Verfahrens zum Erstellen eines Bondplanes für ein elektronisches Bauteil mit einem Halbleiterchip und mit einem Gehäuse und/oder zum Ausführen eines Verfahrens zum Erzeugen von Geometriedaten für die Erstellung von Photomasken für die Belichtung eines elektronischen Bauteils mit einem Halbleiterchip und mit einem Gehäuse mittels photolithographischer Verfahren verwirklicht.

Das Computerprogramm enthält dabei Programmanweisungen, die ein Computersystem veranlassen, solche Verfahren in einer vorstehend beschriebenen Ausführungsform auszuführen. Das Computerprogramm gibt als Ergebnis die bestimmten Kontaktflächenanordnungsdaten, den erstellten Bondplan bzw. die erzeugten Geometriedaten für die nachfolgende Erstellung der Photomasken auf einer Ausgabeeinheit aus, insbesondere auf einem Bildschirm oder auf einem Drucker. Basierend auf diesen Daten können weitere Entwurfsschritte ausgeführt und/oder Fertigungsmaschinen betrieben werden.

Durch das erfindungsgemäße Computerprogramm ergibt sich ein realitätsgetreuer, präziser und fehlerarmer Entwurf von Halbleiterchips, von Gehäusen und von elektronischen Bauteilen. Des weiteren können durch den Einsatz des erfindungsgemäßen Computerprogramms auch umfangreiche und komplexe elektronische Bauteile entworfen werden, die mit den bisher eingesetzten Verfahren, bei denen noch umfangreiche manuelle Arbeitsschritte nötig waren, bisher nicht oder nur mit großen Qualitätsverlusten entworfen werden konnten.

Die Erfindung betrifft außerdem ein Computerprogramm, das auf einem Speichermedium enthalten ist, das in einem Computerspeicher abgelegt ist, das in einem Nur-Lesespeicher bzw. in einem Read-Only-Speicher enthalten ist oder das auf einem elektrischen Trägersignal übertragen wird.

Die Erfindung betrifft auch ein Trägermedium, insbesondere einen Datenträger, wie beispielsweise eine Diskette, ein Zip-Laufwerk, einen Streamer, eine CD oder eine DVD, auf denen ein vorstehend beschriebenes Computerprogramm abgelegt ist. Ferner betrifft die Erfindung ein Computersystem, auf dem ein solches Computerprogramm gespeichert ist. Schließlich betrifft die Erfindung ein Verfahren, bei dem ein solches Computerprogramm aus einem elektronischen Datennetz, wie beispielsweise aus dem Internet auf einen an das Datennetz angeschlossenen Computer heruntergeladen wird.

Die Erfindung ist in den Zeichnungen anhand eines Ausführungsbeispiels näher veranschaulicht.
- Figur 1: zeigt ein erstes Ablaufdiagramm einer ersten Variante des erfindungsgemäßen Verfahrens zum Bestimmen der Anordnung von Kontaktflächen auf der aktiven Oberseite eines Halbleiterchips,
- Figur 2: zeigt ein zweites Ablaufdiagramm einer zweiten Variante dieses erfindungsgemäßen Verfahrens,
- Figur 3: zeigt ein drittes Ablaufdiagramm einer dritten Variante dieses erfindungsgemäßen Verfahrens,
- Figur 4: zeigt ein viertes Ablaufdiagramm des erfindungsgemäßen Verfahrens zum Erstellen eines Bondplanes für ein elektronisches Bauteil mit einem Halbleiterchip und mit einem Gehäuse,
- Figur 5: zeigt ein fünftes Ablaufdiagramm des erfindungsgemäßen Verfahrens zum Erzeugen von Geometriedaten für die Erstellung von Photomasken für die Belichtung eines elektronischen Bauteils mit einem Halbleiterchip und mit einem Gehäuse mittels photolithographischer Verfahren,
- Figur 6: zeigt eine schematische Draufsicht auf ein erfindungsgemäßes erstes elektronisches Bauteil,
- Figur 7: zeigt eine schematische Draufsicht auf ein erfindungsgemäßes zweites elektronisches Bauteil,
- Figur 8: zeigt eine schematische Draufsicht auf ein erfindungsgemäßes drittes elektronisches Bauteil,
- Figur 9: zeigt eine schematische Draufsicht auf ein erfindungsgemäßes drittes elektronisches Bauteil mit einem bereits grob strukturierten dritten Halbleiterchip,
- Figur 10: zeigt eine schematische Darstellung eines erfindungsgemäßen Bondplanes.

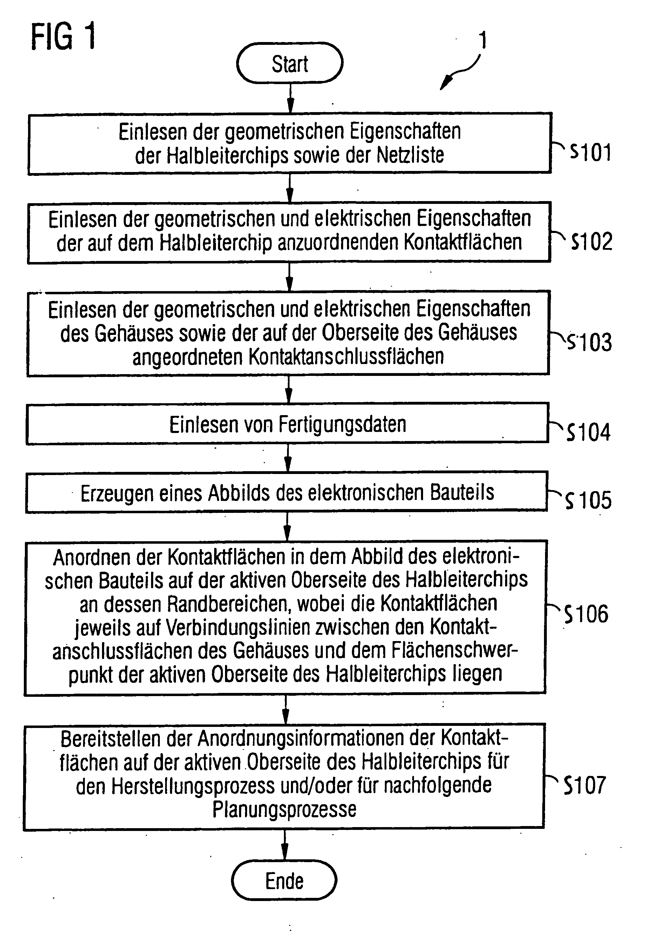

Figur 1 zeigt ein erstes Ablaufdiagramm 1 einer ersten Variante des erfindungsgemäßen Verfahrens zum Bestimmen der Anordnung von Kontaktflächen auf der aktiven Oberseite eines Halbleiterchips.

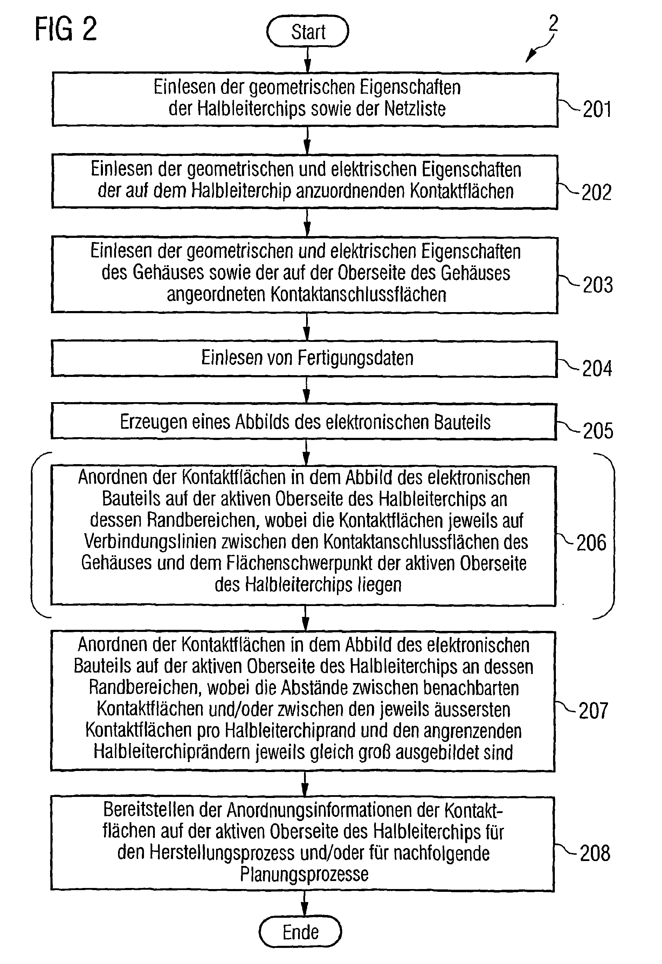

Figur 2 zeigt ein zweites Ablaufdiagramm 2 einer zweiten Variante dieses erfindungsgemäßen Verfahrens.

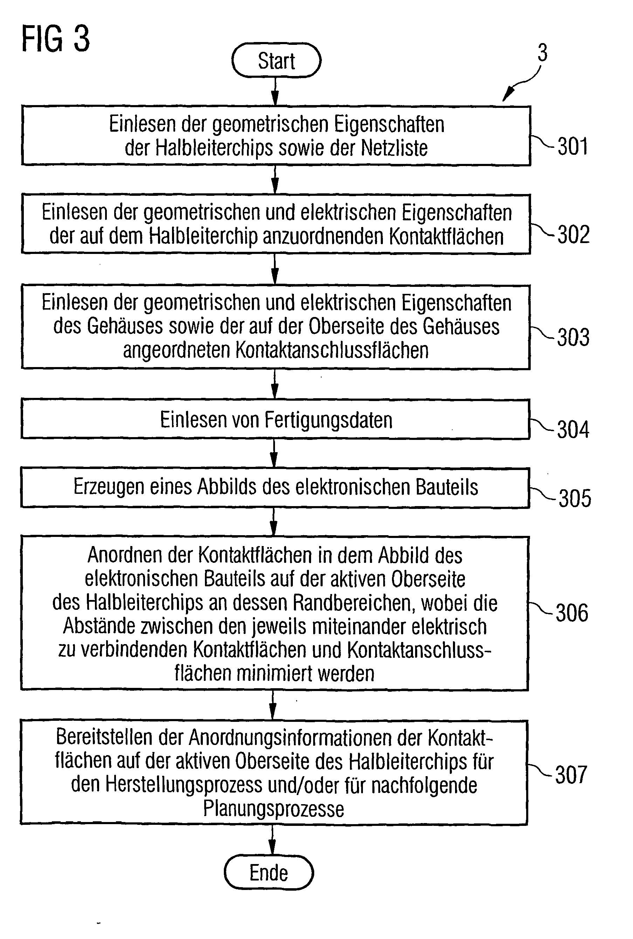

Figur 3 zeigt ein drittes Ablaufdiagramm 3 einer dritten Variante des erfindungsgemäßen Verfahrens.

Sämtliche Verfahrensschritte der in den Ablaufdiagrammen 1 bis 3 dargestellten Verfahrensvarianten werden auf einem Computersystem ausgeführt. Die jeweils ersten fünf Verfahrensschritte sowie der jeweils letzte Verfahrensschritt des erfindungsgemäßen Verfahrens zur Bestimmung der Anordnung von Kontaktflächen auf einem Halbleiterchip stimmen für alle drei Verfahrensvarianten jeweils überein und werden dementsprechend zusammen erläutert.

Zu Beginn des Verfahrens wählt ein Benutzer ein Gehäuse, sowie einen Halbleiterchip aus, der auf bzw. in dem Gehäuse plaziert werden soll. Beschreibungen des Halbleiterchips sowie des Gehäuses sind in Datenform auf dem Computersystem abgespeichert, insbesondere als separate Dateien.

Im ersten erfindungsgemäßen Verfahren S101, S102 bzw. S103 werden die in Dateien gespeicherten geometrischen Eigenschaften des Halbleiterchips sowie die Netzliste, die Informationen über die Anzahl der an jedem Rand des Halbleiterchips anzuordnenden Kontaktflächen beinhaltet, in einen Arbeitsspeicherbereich des Computersystems eingelesen. Im zweiten erfindungsgemäßen Verfahrensschritt S102, 202 bzw. 302 werden die geometrischen und elektrischen Eigenschaften der auf dem Halbleiterchip anzuordnenden Kontaktflächen eingelesen. Diese Daten sind ebenfalls in Dateien abgespeichert und enthalten Informationen über den Kontaktflächentyp, beispielsweise Signalpad oder Versorgungspad, über die Abmessungen der Kontaktflächen und über die um die Kontaktflächen herum einzuhaltenden Mindestabstände.

Im dritten erfindungsgemäßen Verfahrensschritt S103, 203 bzw. 303 werden die geometrischen und elektrischen Eigenschaften des Gehäuses sowie der auf der Oberseite des Gehäuses angeordneten Kontaktanschlußflächen in den Arbeitsspeicherbereich des Computersystems eingelesen. Diese Daten liegen ebenfalls in Dateien vor. Die genaue Position der Kontaktanschlußflächen auf der Oberseite des Gehäuses ist dabei vorgegeben und eine Voraussetzung des in diesem Ausführungsbeispiel beschriebenen erfindungsgemäßen Verfahrens.

Im vierten Verfahrensschritt S104, 204 bzw. 304 werden fertigungsspezifische Daten, die in ebenfalls in Form von Dateien vorliegen, in den Arbeitsspeicherbereich des Computersystems eingelesen. Diese fertigungsspezifischen Daten werden auch als "design rules" bezeichnet und legen unter anderem die Anordnung des Halbleiterchips in bezug zu dem Gehäuse fest. Die Struktur solcher "design rules" ist dem Fachmann geläufig und braucht hier nicht näher erläutert zu werden.

Aus den in den ersten vier verfahrensschritten eingelesenen Daten erzeugt das Computersystem nun ein Abbild des elektronischen Bauteils, das ein Gehäuse sowie ein in bzw. auf dem Gehäuse angeordneten Halbleiterchip aufweist. Dieses Abbild ist dabei als Graphik mit hinterlegten geometrischen und elektrischen Daten ausgebildet, liegt auf dem Arbeitsspeicherbereich des Computersystems vor und wird auf einer Ausgabeeinheit, insbesondere auf einem Bildschirm visualisiert.

Die nun folgenden Verfahrensschritte betreffen die Anordnung der Kontaktflächen in dem Abbild des elektronischen Bauteils auf der aktiven Oberseite des Halbleiterchips an dessen Randbereichen. Diese Anordnung wird in den drei Verfahrensvarianten unterschiedlich vorgenommen.

Bei der im ersten Ablaufdiagramm 1 dargestellten Verfahrensvariante sieht der sechste Verfahrensschritt S106 eine nahezu oder vollständig radiale Anordnung der Kontaktflächen jeweils auf Verbindungslinien zwischen den Kontaktanschlußflächen des Gehäuses und dem Flächenschwerpunkt der aktiven Oberseite des Halbleiterchips vor.

Die Anordnung der Kontaktflächen in dem Abbild des elektronischen Bauteils kann gemäß der im zweiten Ablaufdiagramm 2 dargestellten Verfahrensvariante durch eine sukzessive Ausführung des sechsten Verfahrensschritts 206 und des siebten Verfahrensschritts 207 erfolgen.

Bei der ersten Ausführungsweise der zweiten Variante werden die Kontaktflächen zunächst auf Verbindungslinien zwischen den Kontaktanschlußflächen des Gehäuses und dem Flächenschwerpunkt der aktiven Oberseite des Halbleiterchips angeordnet und danach auf einen jeweils gleichen Abstand zwischen den jeweils benachbarten Kontaktflächen geschoben. Der gleiche Abstand kann auch zwischen den jeweils äußersten Kontaktflächen pro Halbleiterchiprand und den jeweils angrenzenden Halbleiterchiprändern vorgesehen werden. Durch die vorherige Ausführung des sechsten Verfahrensschritts 206 wird sichergestellt, daß die Kontaktflächen an denjenigen Halbleiterchiprändern angeordnet werden, die den Kontaktanschlußflächen auf dem Gehäuse jeweils am nächsten liegen.

Bei der im sechsten Verfahrensschritt 306 des dritten Ablaufdiagramms 3 dargestellten dritten Verfahrensvariante werden die Kontaktflächen in dem Abbild des elektronischen Bauteils angeordnet, indem die Abstände zwischen den jeweils miteinander elektrisch zu verbindenden Kontaktflächen und Kontaktanschlußflächen minimiert werden. Dabei wird versucht, wenn möglich, die Kontaktflächen direkt gegenüber der Kontaktanschlußflächen zu positionieren. Falls das nicht möglich ist, so wird unter Berücksichtigung der durch die Anzahl der auf jedem Chiprand zu positionierenden Kontaktflächen versucht, den Winkel zwischen der gedachten gerade ausgebildeten Bondverbindung zwischen Kontaktfläche und Kontaktanschlußfläche sowie dem betreffenden Halbleiterchiprand möglichst nahe einem rechten Winkel zu wählen.

Der letzte erfindungsgemäße Verfahrensschritt S107, 208, 307 stimmt für alle drei Verfahrensvarianten überein und umfaßt das Bereitstellen der Anordnungsinformation der Kontaktflächen auf der aktiven Oberseite des Halbleiterchips für den Herstellungsprozeß und/oder für nachfolgende Planungsprozesse.

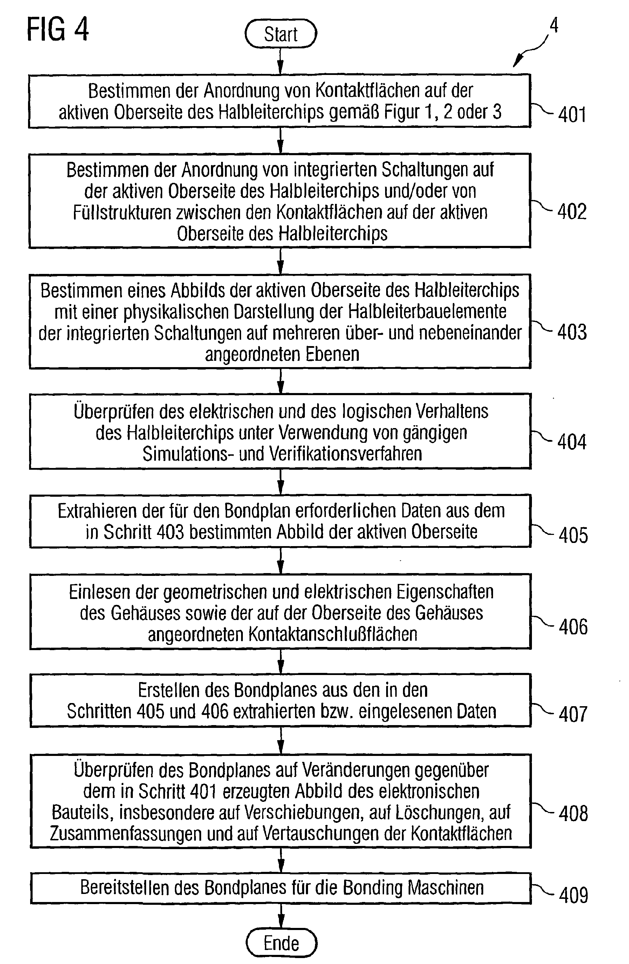

Figur 4 zeigt ein viertes Ablaufdiagramm 4 des erfindungsgemäßen Verfahrens zum Erstellen eines Bondplanes für ein elektronisches Bauteil mit einem Halbleiterchip und mit einem Gehäuse.

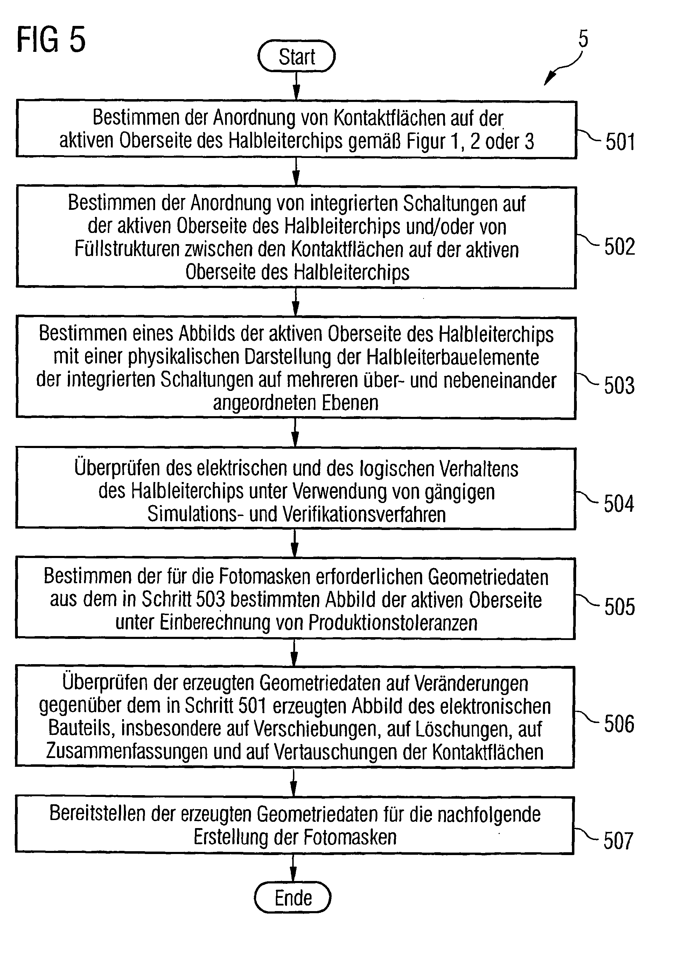

Figur 5 zeigt ein fünftes Ablaufdiagramm 5 des erfindungsgemä-ßen Verfahrens zum Erzeugen von Geometriedaten für die Erstellung von Photomasken für die Belichtung eines elektronischen Bauteils mit einem Halbleiterchip und mit einem Gehäuse mittels photolithographischer Verfahren.

Die in den Ablaufdiagrammen 4 und 5 dargestellten Verfahren weisen zu Beginn die vier jeweils übereinstimmenden Verfahrensschritte 401 bis 404 bzw. 501 bis 504 auf, die nachfolgend zusammengefaßt erklärt werden.

Beide Verfahren setzen auf der vorherigen Durchführung des erfindungsgemäßen Verfahrens zum Bestimmen der Anordnung von Kontaktflächen auf der aktiven Oberseite eines Halbleiterchips auf. Die Varianten dieses Verfahrens sind bereits in den Figuren 1 bis 3 erläutert worden. Die Verfahrensschritte 401 bzw. 501 liefern somit die Anordnungsinformationen der Kontaktflächen auf der aktiven Seite des Halbleiterchips in Form von geometrischen Daten.

Der zweite Verfahrensschritt 402 bzw. 502 sieht das Bestimmen der Anordnung von integrierten Schaltungen auf der aktiven Oberseite des Halbleiterchip und/oder von Füllstrukturen zwischen den Kontaktflächen auf der aktiven Oberseite des Halbleiterchips vor. Dabei werden die integrierten Schaltungen als black boxes betrachtet und anhand ihrer geschätzten Dimensionen auf der aktiven Oberseite des Halbleiterchips unter Verwendung von dem Fachmann bekannten Plazierungsalgorithmen angeordnet. In den Randbereichen des Halbleiterchips werden Füllstrukturen zwischen den Kontaktflächen vorgesehen, um die Spannungsversorgung bzw. die elektrische Verbindung zwischen den Kontaktflächen zu gewährleisten.

Der dritte Verfahrensschritt 403 bzw. 503 sieht das Bestimmen eines Abbilds der aktiven Oberseite des Halbleiterchips in Form einer physikalischen Darstellung der integrierten Schaltungen auf mehreren über- bzw. nebeneinander angeordneten Ebenen vor. Dabei werden die integrierten Schaltungen nicht mehr als black boxes, sondern in ihrer mikroskopisch kleinen physikalischen Struktur mit Halbleiterbauteilen, z.B. Transistoren, Widerständen, Induktivitäten und Kapazitäten betrachtet. Diese sind in dem Abbild der aktiven Oberseite des Halbleiterchips bereits miteinander verdrahtet. Das Abbild der aktiven Oberseite des Halbleiterchips umfaßt auch die Kontaktflächen.

Im darauffolgenden vierten Verfahrensschritt 404 bzw. 504 wird das elektrische bzw. das logische Verhalten des bestimmten Abbilds des Halbleiterchips unter Verwendung von gängigen, dem Fachmann geläufigen Simulations- und Verifikationsverfahren überprüft. Falls an dieser Stelle Fehler detektiert werden, so bricht das jeweilige Verfahren ab.

Nachfolgend werden zunächst die weiteren Verfahrensschritte des in Figur 4 gezeigten Verfahrens zum Erstellen eines Bondplanes erläutert.

Im fünften Verfahrensschritt 405 werden die für den Bondplan erforderlichen Daten aus dem in Schritt 403 bestimmten Abbild der aktiven Oberseite des Halbleiterchips extrahiert. Dabei handelt es sich um Daten bezüglich der Anordnung und der Eigenschaften der Kontaktflächen und um Daten bezüglich der Geometrie und Anordnung des Halbleiterchips. Im nächsten Verfahrensschritt 406 werden die geometrischen und elektrischen Eigenschaften des Gehäuses sowie der auf der Oberfläche des Gehäuses angeordneten Kontaktanschlußflächen in den Arbeitsspeicherbereich des Computersystems eingelesen. Dabei kann es sich sowohl um die in den Figuren 1 bis 3 in Schritt S103 bzw. 203 bzw. 303 eingelesenen Daten handeln. Es ist weiterhin möglich, daß diese Daten weiterverarbeitet worden sind, beispielsweise durch eine Gehäuseerstellung, durch eine Simulation, durch eine Kontaktvorlagenerstellung und/oder durch eine Abspeicherung in einem Standardformat, beispielsweise GDSII.

Aus den in Schritt 405 extrahierten Daten sowie aus den in Schritt 406 eingelesenen Daten wird nun ein Bondplan erstellt. Bei diesem Bondplan handelt es sich um eine graphische Darstellung mit hinterlegten, auf einen festen Nullpunkt bezogenen geometrischen Daten auf dem Computersystem bzw. auf einer Ausgabeeinheit, insbesondere auf einem Bildschirm oder einem Drucker des Computersystems. Im darauffolgenden achten Verfahrensschritt 408 wird dieser Bondplan auf Veränderungen gegenüber demjenigen Abbild des elektronischen Bauteils untersucht, das im Schritt 401 bzw. in den Verfahrensschritten S105, 205 bzw. 305 der Ablaufdiagramme 1, 2 bzw. 3 erstellt worden ist. Diese Überprüfung konzentriert sich insbesondere auf Löschungen, auf Zusammenfassungen sowie auf Vertauschungen von Kontaktflächen. Falls gravierende Abweichungen festgestellt werden, so erfolgt die Ausgabe einer Fehlermeldung auf dem Bildschirm des Computersystems. Das Verfahren kann in diesem Fall an dieser Stelle abgebrochen werden. Falls dieser Überprüfungsschritt keine Fehler bzw. Abweichungen ergibt, so wird im letzten Verfahrensschritt 409 der Bondplan für die Bonding-Maschinen bereitgestellt.

Nachfolgend werden die weiteren Verfahrensschritte des in Figur 5 gezeigten Verfahrens zum Erzeugen von Geometriedaten für die Erstellung von Photomasken ab dem fünften Verfahrensschritt 505 erläutert.

In diesem fünften Verfahrensschritt 505 werden die für die Photomasken erforderlichen Geometriedaten aus dem Abbild der aktiven Oberseite des Halbleiterchips bestimmt. Dabei werden Produktionstoleranzen einberechnet. Die Informationen, die von solchen für die Photomasken erforderlichen Geometriedaten umfaßt werden, sind dem Fachmann bekannt und brauchen hier nicht weiter erläutert zu werden.

Im sechsten Verfahrensschritt 506 werden die erzeugten Geometriedaten auf Veränderungen gegenüber dem in Schritt 501 bzw. in den Verfahrensschritten S105, 205 bzw. 305 der Ablaufdiagramme 1, 2 bzw. 3 erzeugten Abbild des elektronischen Bauteils überprüft. Diese Überprüfung erfolgt insbesondere auf Verschiebungen, auf Löschungen, auf Zusammenfassungen und auf Vertauschungen der Kontaktflächen. Falls Veränderungen festgestellt werden, so erfolgt eine Ausgabe einer Fehlermeldung auf dem Bildschirm des Computersystems. Das erfindungsgemäße Verfahren kann an dieser Stelle abgebrochen werden. Im letzten Verfahrensschritt werden die erzeugten Geometriedaten für die nachfolgende Erstellung der Photomasken bereitgestellt. Basierend auf diesen Geometriedaten können die Photomasken für die Belichtung der Oberfläche des Halbleiterchips unmittelbar erstellt werden.

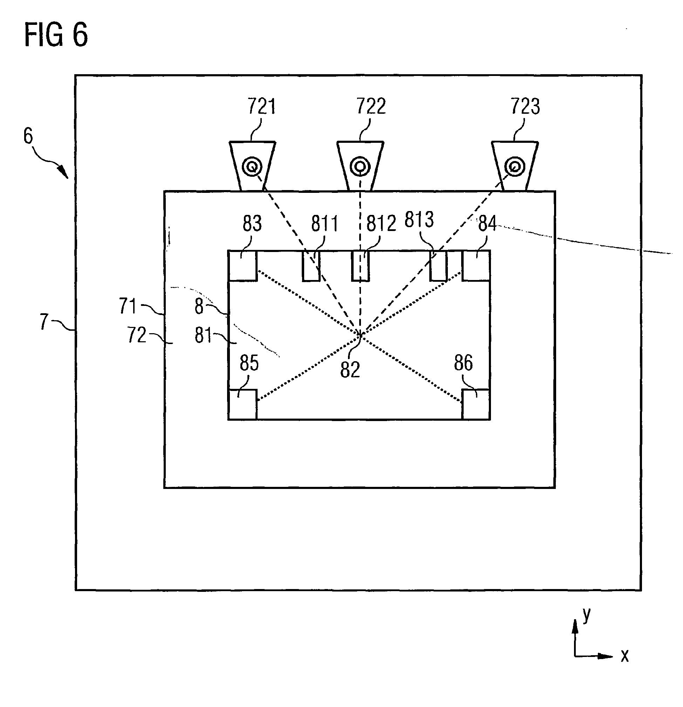

Figur 6 zeigt eine schematische Draufsicht auf ein erstes elektronisches Bauteil 6.

Nachfolgend werden die Begriffe "oben" und "unten" jeweils bezogen auf die Richtung der y-Achse des in Figur 6 dargestellten Koordinatensystems und die Begriffe "rechts " und "links" jeweils bezogen auf die Richtung der x-Achse des Koordinatensystems verwendet. Dies gilt sinngemäß für die Figuren 6 bis 10.

In Figur 6 ist ein längliches rechteckiges Gehäuse 7 erkennbar, das eine ebenfalls längliche rechteckige zentrierte Fläche 72 aufweist, die von einer Linie 71 umgeben ist. An der oberen Seite dieser Linie 71 sind nebeneinander eine erste Kontaktanschlußfläche 721, eine zweite Kontaktanschlußfläche 722 und eine dritte Kontaktanschlußfläche 723 angeordnet. Diese weisen jeweils eine trapezartige Form auf und grenzen mit ihrer Schmalseite an die obere Seite der Linie 71. Mittig in den Kontaktanschlußflächen 721 bis 723 ist jeweils ein Lotball dargestellt. Die zweite Kontaktanschlußfläche 722 ist zentriert bezüglich der oberen Seite des Innenrands angeordnet. Die erste Kontaktanschlußfläche 721 befindet sich ungefähr mittig zwischen dem linken Ende der oberen Seite der Linie 71 und der zweiten Kontaktanschlußfläche 722. Die dritte Kontaktanschlußfläche 723 befindet sich nahe dem rechten Ende der oberen Seite der Linie 71.

Innerhalb der Fläche 72 ist ein ebenfalls länglicher rechteckiger erster Halbleiterchip 8 vorgesehen, der mit seiner nicht gezeigten passiven Rückseite mittig auf der Fläche 72 befestigt ist. Dementsprechend ist in Figur 6 seine aktive Oberseite 81 sichtbar, die sich ungefähr auf gleicher Höhe wie die Vorderseite des Gehäuses 7 befindet. An den vier Ecken des ersten Halbleiterchips 8 sind jeweils grau unterlegte quadratische Eckbereiche 83, 84, 85 und 86 angeordnet. Des weiteren sind in Figur 6 die Diagonalen der aktiven Oberseite 81 mit punktierten Hilfslinien dargestellt. Der Schnittpunkt der beiden Diagonalen stellt den Flächenschwerpunkt 82 der aktiven Oberseite 81 dar. Zwischen den Kontaktanschlußflächen 721 bis 723 und dem Flächenschwerpunkt 82 verlaufen in Figur 6 gestrichelt dargestellte und gerade ausgebildete Verbindungslinien. An dem oberen Rand der aktiven Oberseite 81 sind Kontaktflächen 811 bis 813 plaziert. Die erste Kontaktfläche 811 befindet sich dabei auf der Verbindungslinie zwischen dem Flächenschwerpunkt 82 und der ersten Kontaktanschlußfläche 721, die zweite Kontaktfläche 812 liegt auf der Verbindungslinie zwischen dem Flächenschwerpunkt 82 und der zweiten Kontaktanschlußfläche 722 und die dritte Kontaktfläche 813 ist auf der Verbindungslinie zwischen dem Flächenschwerpunkt 82 und der dritten Kontaktanschlußfläche 723 angeordnet.

Nachfolgend wird das erfindungsgemäße Verfahren zum Bestimmen der Anordnung von Kontaktflächen gemäß dem ersten Ablaufdiagramm 1 anhand des ersten elektronischen Bauteils 6 erläutert. Durch einen Benutzer wird zu Beginn festgelegt, daß der erste Halbleiterchip 8 auf der Fläche 72 des Gehäuses 7 plaziert werden soll. Dies geschieht, indem der Benutzer das Gehäuse 7 sowie den ersten Halbleiterchip 8, deren geometrische und elektrische Eigenschaften in Form von Daten auf dem Computersystem abgelegt sind, auf einem hier nicht gezeigten üblichen Computersystem auswählt.

Dann werden die geometrischen Eigenschaften des Halbleiterchips des ersten Halbleiterchips 8, nämlich dessen Länge und dessen Breite sowie die Dimensionen der Eckbereiche 83 bis 86 sowie die Netzliste eingelesen, welche die Anzahl sowie die Reihenfolge der drei Kontaktflächen 811 bis 813 vorsieht. Danach werden von einer getrennten Datenbank die geometrischen und elektrischen Eigenschaften der drei Kontaktflächen 811 bis 813 eingelesen. Weiterhin werden die geometrischen und elektrischen Eigenschaften des Gehäuses 7 sowie der Kontaktanschlußflächen 721 bis 723 eingelesen. Schließlich werden die Fertigungsdaten eingelesen, welche die Anordnung des ersten Halbleiterchips 8 in dem Gehäuse 7 festlegen.

Aus diesen eingelesenen Daten erzeugt das Computersystem ein Abbild des elektronischen Bauteils, das der Darstellung in Figur 6 entspricht, wobei die genaue Anordnung der Kontaktflächen 811 bis 813 noch nicht festgelegt ist. Diese genaue Anordnung wird nun im nächsten Verfahrensschritt bestimmt. Dabei werden von den Kontaktanschlußflächen 721 bis 723 jeweils gerade ausgebildete Hilfslinien zu dem Flächenschwerpunkt 82 gezogen. Die Kontaktflächen 811 bis 813 werden nun so an dem oberen Rand des ersten Halbleiterchips 8 positioniert, daß die Mitte der Oberseite der Kontaktflächen 811 bis 813 jeweils an den Schnittpunkten der Verbindungslinien mit dem oberen Rand der aktiven Oberseite 81 des ersten Halbleiterchips 8 liegen. Die derartige Anordnung der Kontaktflächen 811 bis 813 wird in Form von geometrischen Daten gespeichert. Diese Daten können für den nachfolgenden Herstellungsprozeß und/oder für nachfolgende Planungs- und Entwurfsprozesse genützt werden.

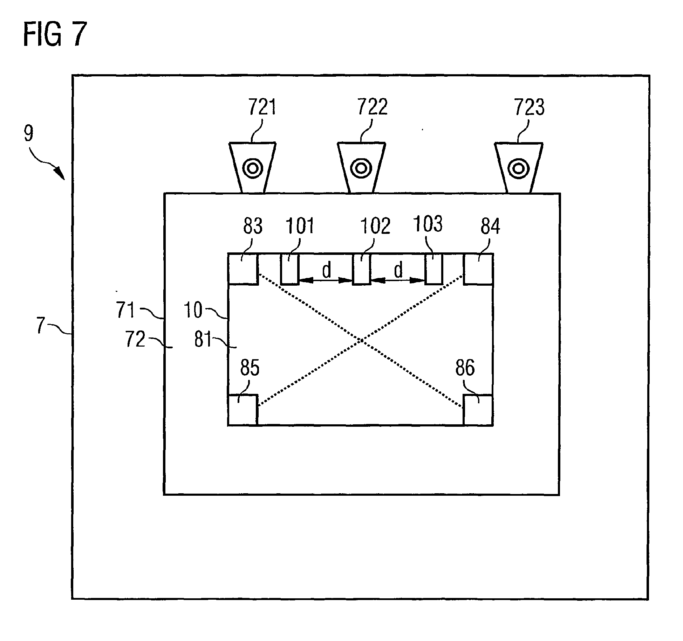

Figur 7 zeigt eine schematische Draufsicht auf ein zweites elektronisches Bauteil 9.

Dieses zweite elektronische Bauteil 9 gliedert sich in das bereits beschriebene Gehäuse 7 sowie in einen zweiten Halbleiterchip, der mit seiner passiven Rückseite innerhalb der Fläche 72 aufgebracht ist. Dabei stimmt der zweite Halbleiterchip 10 hinsichtlich seiner Anordnung in bezug zu dem Gehäuse 7, hinsichtlich seiner Abmessungen und hinsichtlich der Eckbereiche 83 bis 86 mit dem ersten Halbleiterchip 8 überein.

An dem oberen Rand der aktiven Oberseite 81 des zweiten Halbleiterchips 10 befinden sich eine vierte Kontaktfläche 101, eine fünfte Kontaktfläche 102 sowie eine sechste Kontaktfläche 103. Die fünfte Kontaktfläche 102 ist dabei mittig bezüglich des oberen Randes der aktiven Oberseite 81 des zweiten Halbleiterchips 10 angeordnet. Die vierte Kontaktfläche 101 befindet sich links von der fünften Kontaktfläche 102, und die sechste Kontaktfläche 103 befindet sich rechts von der fünften Kontaktfläche 102. Dabei ist zwischen der vierten Kontaktfläche 101 und der fünften Kontaktfläche 102 sowie zwischen der fünften Kontaktfläche 102 und der sechsten Kontaktfläche 103 jeweils ein gleich großer Abstand d vorgesehen.

Nachfolgend wird das erfindungsgemäße Verfahren zur Bestimmung der Anordnung von Kontaktflächen gemäß dem zweiten Ablaufdiagramm 2 anhand des zweiten elektronischen Bauteils 9 erläutert.

Die ersten fünf Verfahrensschritte 201 bis 205 stimmen dabei mit den bei der Erläuterung von Figur 6 beschriebenen Verfahrensschritten S101 bis S105 überein und werden nicht noch einmal abgehandelt.

Bei der Ausführung des erfindungsgemäßen Verfahrens gemäß Figur 2 kann der Verfahrensschritt 206 ausgeführt werden, der dem bereits in Figur 6 erläuterten Verfahrensschritt 106 entspricht und deshalb nicht noch einmal erklärt wird. Dieser Verfahrensschritt 206 dient dabei in Figur 7 als vorbereitender Schritt für den siebten Verfahrensschritt 207.

In dem siebten Verfahrensschritt 207 werden die Kontaktflächen 101 bis 103 an dem oberen Rand der aktiven Oberseite des zweiten Halbleiterchips 10 gleichverteilt angeordnet. Dabei wird zwischen den benachbarten Kontaktflächen 101 und 102 bzw. 102 und 103 jeweils ein gleich großer Abstand d eingehalten. Dieser Abstand d kann benutzerdefiniert vorgegeben werden oder aus der Anzahl der Kontaktflächen pro Seitenrand und aus der Breite des Seitenrandes bestimmt werden. In einem hier nicht gezeigten Ausführungsbeispiel kann dieser Verfahrensschritt 207 auch so vorgesehen werden, daß der Abstand d auch zwischen den jeweils äußersten Kontaktflächen pro Seitenrand und den angrenzenden Seitenrändern des Halbleiterchips bzw. und den freizuhaltenden Randbereichen vorgesehen ist. Die Anordnungsinformationen der Kontaktflächen 101 bis 103 auf der aktiven Oberseite 81 des zweiten Halbleiterchips 10 können nachfolgenden Herstellungs- oder Planungsprozessen bereitgestellt werden.

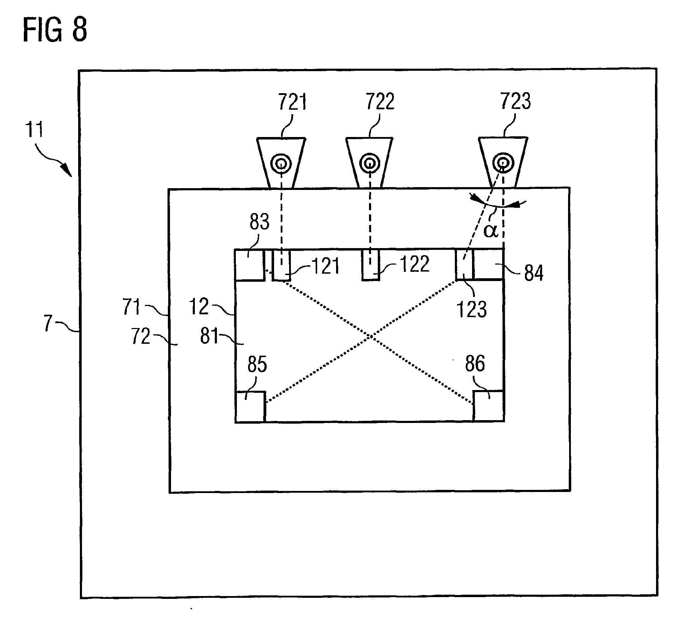

Figur 8 zeigt eine schematische Draufsicht auf ein drittes elektronisches Bauteil 11.

Das dritte elektronische Bauteil 11 gliedert sich in das bereits beschriebene Gehäuse 7 sowie in einen dritten Halbleiterchip 12, der mit seiner passiven Rückseite auf die Fläche 72 montiert ist. Dabei entspricht der dritte Halbleiterchip 12 hinsichtlich seiner Abmessung, hinsichtlich seiner Ausrichtung gegenüber dem Gehäuse 7 und hinsichtlich seiner Eckbereiche 83 bis 86 dem in Figur 6 beschriebenen ersten Halbleiterchip 8.

An dem oberen Seitenrand der aktiven Oberseite 81 des dritten Halbleiterchips 12 sind die Kontaktflächen 121 bis 123 angeordnet. Dabei liegt die siebte Kontaktfläche 121 senkrecht unter der ersten Kontaktanschlußfläche 721. Die achte Kontaktfläche 122 befindet sich senkrecht unter der zweiten Kontaktanschlußfläche 722. Die neunte Kontaktfläche 123 grenzt links an den Eckbereich 84 an. Die Bondverbindungen zwischen den Kontaktflächen 121 bis 123 sowie den Kontaktanschlußflächen 721 bis 723 sind durch gestrichelte Linien in Figur 8 angedeutet. Die Bondverbindungen zwischen den Kontaktflächen 121, 122 und den Kontaktanschlußflächen 721, 722 verlaufen dabei jeweils senkrecht. Die Bondverbindungen zwischen der neunten Kontaktfläche 123 und der dritten Kontaktanschlußfläche 723 verläuft in einem Winkel α zu einer gedachten senkrechten Verbindung zwischen der dritten Kontaktanschlußfläche 723 und dem oberen Seitenrand der aktiven Oberseite 81 des dritten Halbleiterchips 12.

Nachfolgend ist das erfindungsgemäße Verfahren zum Bestimmen der Anordnung von Kontaktflächen gemäß Figur 3 anhand des in Figur 8 dargestellten dritten elektronischen Bauteils 11 erläutert.

Die ersten fünf Verfahrensschritte 301 bis 305 stimmen mit den mit bezug auf die Figur 6 beschriebenen Verfahrensschritten 101 bis 105 überein und werden nicht extra erläutert. Der sechste Verfahrensschritt 306 sieht das drahtlängenoptimierte Anordnen der Kontaktflächen 121 bis 123 in dem Abbild des dritten elektronischen Bauteils 11 auf der aktiven Oberseite 81 des dritten Halbleiterchips 12 an dessen Randbereichen vor. Die siebte Kontaktfläche 121 und die achte Kontaktfläche 122 können dabei direkt unter der ersten Kontaktanschlußfläche 721 bzw. der zweiten Kontaktanschlußfläche 722 angeordnet werden, wodurch eine kürzest mögliche senkrechte Bondverbindung geschaffen werden kann. Die neunte Kontaktfläche 123 kann nicht direkt unter der dritten Kontaktanschlußfläche 723 angeordnet werden. Bei dem dritten Halbleiterchip 12 ist nämlich ein freizuhaltender Eckbereich 84 vorgesehen, in dem keinerlei Kontaktflächen angeordnet werden dürfen. Dementsprechend wird die neunte Kontaktfläche 123 so an dem oberen Rand der aktiven Oberseite 81 des dritten Halbleiterchips 12 direkt neben dem Eckbereich 84 plaziert, daß der Winkel α ihrer gerade ausgebildeten Bondverbindung zu der dritten Kontaktanschlußfläche 723 minimal in bezug zu der senkrechten Anordnung ausgebildet ist.

Die so bestimmte Anordnung der Kontaktflächen 121 bis 123 wird nun in Form von geometrischen Daten abgespeichert, die für weitere Herstellungs- und/oder Planungsprozesse verwendet werden können.

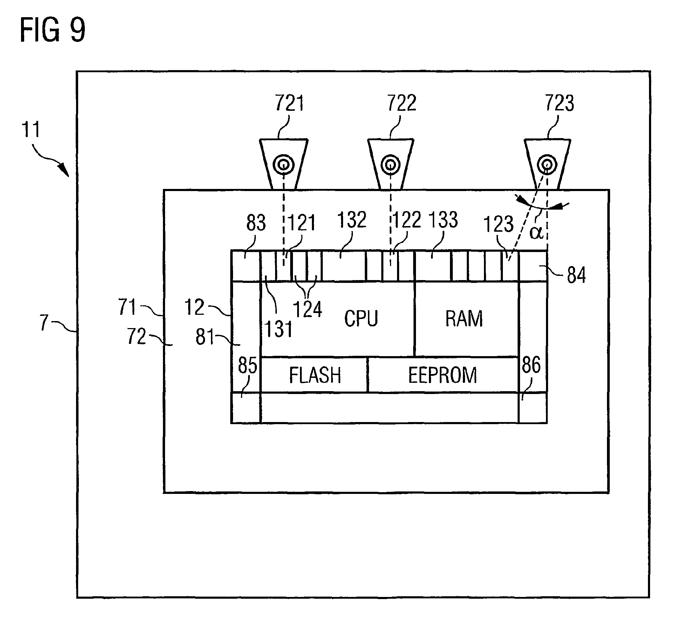

Figur 9 zeigt eine schematische Draufsicht auf ein drittes elektronisches Bauteil 11, das den grob strukturierten dritten Halbleiterchip 12 umfaßt.

Dabei entsprechen das Gehäuse 7 und die Abmessungen, die Anordnung, die Eckbereiche 83-86 und die Kontaktflächen 121-123 des dritten Halbleiterchips 12 der in Figur 8 gezeigten Darstellung.

Rechts an die siebte Kontaktfläche 121 angrenzend sind zwei weitere Kontaktflächen 124 vorgesehen. Jeweils links und rechts an die achte Kontaktfläche 122 angrenzend befinden sich ebenfalls zwei weitere Kontaktflächen 124. Links neben der neunte Kontaktfläche 123 sind drei weitere Kontaktflächen 124 angeordnet. Die Kontaktflächen 121-124 weisen jeweils die gleiche Form auf.

Zwischen dem Eckbereich 83 und der siebten Kontaktfläche 121 ist eine erste Füllstruktur 131 plaziert. Zwischen den Kontaktflächenblöcken, in denen sich die siebte Kontaktfläche 121, die achte Kontaktfläche 122 und die neunte Kontaktfläche 123 befinden, sind eine zweite Füllstruktur 132 sowie eine dritte Füllstruktur 133 angeordnet. Diese Füllstrukturen 131 bis 133 gewährleisten die Spannungsversorgung der Kontaktflächen 121 bis 124.

In dem mittleren Bereich der aktiven Oberseite 81 des dritten Halbleiterchips 12 sind integrierte Schaltungen plaziert, nämlich eine erste integrierte Schaltung CPU, ein zweite integrierte Schaltung RAM, eine dritte integrierte Schaltung Flash und eine vierte integrierte Schaltung EEPROM. Dabei befindet sich die erste integrierte Schaltung CPU in einem oberen linken, die zweite integrierte Schaltung RAM in einem oberen rechten, die dritte integrierte Schaltung Flash in einem unteren linken und die vierte integrierte Schaltung EEPROM in einem unteren rechten Bereich der aktiven Oberseite 81 des dritten Halbleiterchips 12.

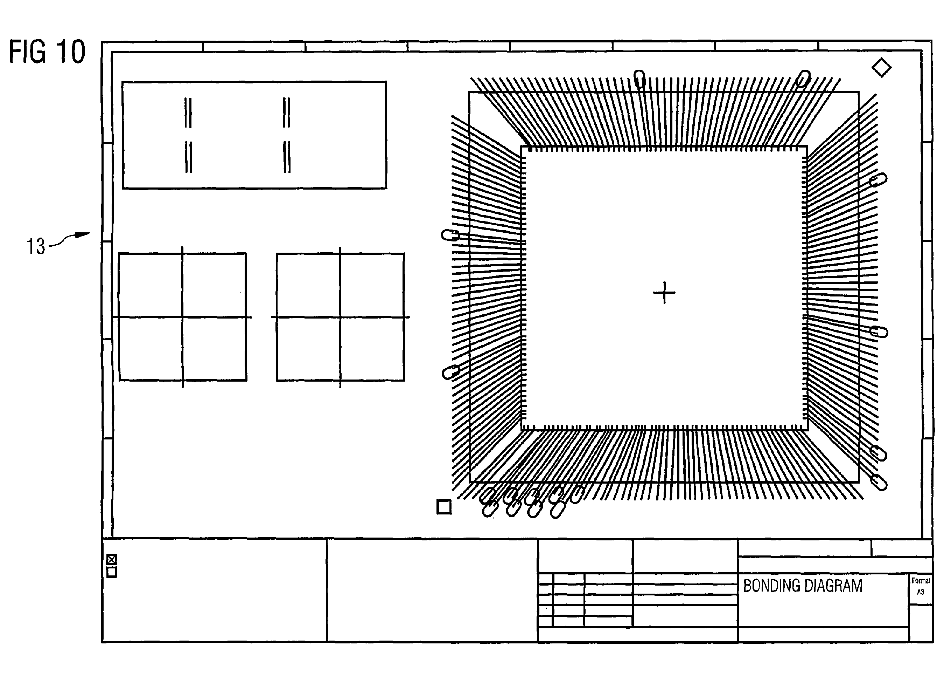

Figur 10 zeigt eine schematische Darstellung eines Bondplanes 13.

Der Bondplan 13 zeigt einen Halbleiterchip sowie ein Gehäuse, in dem der Halbleiterchip angeordnet ist. Zwischen Kontaktflächen auf dem Halbleiterchip und Kontaktanschlußflächen auf dem Gehäuse verlaufen eine Vielzahl von Bondverbindungen.

Dieser Bondplan 13 dient dazu, die Komplexität solch eines Bondplanes aufzuzeigen. Links neben dem Bondplan sowie in einem Fußbereich unter dem Bondplan sind Bereiche vorgesehen, in denen Daten, insbesondere geometrische und elektrische Daten, dargestellt werden können. Der Bondplan 13 kann auf dem Bildschirm eines Computersystems dargestellt werden.

Nachfolgend wird das erfindungsgemäße Verfahren zum Erstellen eines Bondplanes gemäß Figur 4 für das dritte elektronische Bauteil 11 mit bezug auf die Figuren 8-10 erläutert.

Den ersten erfindungsgemäßen Verfahrensschritt 401 bildet dabei das im dritten Ablaufdiagramm 3 veranschaulichte Verfahren zum Bestimmen der Anordnung von Kontaktflächen. Auf die derart bestimmten Anordnungsinformationen der Kontaktflächen 121-123 greift der zweite Verfahrensschritt 402 zurück. Dabei wird an dieser Stelle angenommen, daß sich auch die Anordnungsinformationen der Kontaktflächen 124 aus dem bereits ausgeführten Verfahren zum Bestimmen der Anordnung von Kontaktflächen ergeben.

Im zweiten Verfahrensschritt 402 wird nun die in Figur 9 gezeigte Anordnung der integrierten Schaltungen CPU, RAM, Flash und EEPROM auf der aktiven Oberseite 81 des dritten Halbleiterchips 12 bestimmt. Ferner werden auch die Füllstrukturen 131 bis 133 auf der aktiven Oberseite des Halbleiterchips zwischen den Kontaktflächen 121 bis 124 - wie in Figur 9 gut zu erkennen ist - plaziert. Die dabei verwendeten Pazierungsverfahren sind dem Fachmann bekannt und brauchen hier nicht näher erläutert zu werden.

In nächsten erfindungsgemäßen Verfahrensschritt 403 wird ein Abbild der aktiven Oberseite 81 des dritten Halbleiterchips 12 mit einer physikalischen Darstellung der Halbleiterbauelemente bestimmt. Dieses Abbild umfaßt mehrere über- und nebeneinander angeordnete Ebenen bzw. Materialschichten. Die Struktur eines solchen aufgrund seiner Komplexität nur sehr schwierig darzustellenden Abbildes ist dem Fachmann bekannt. Eine Darstellung eines solchen Abbildes kann daher an dieser Stelle entfallen.

Im nächsten Schritt 404 wird das so bestimmte Abbild des dritten Halbleiterchips 12 unter Verwendung von gängigen, dem Fachmann ebenfalls bekannten Simulations- und Verifikationsverfahren bestimmt.

Im fünften Verfahrensschritts 405 werden die für den Bondplan erforderlichen Daten aus dem in Verfahrensschritts 403 bestimmten Abbild der aktiven Oberseite 81 des dritten Halbleiterchips 12 extrahiert. Diese für den Bondplan erforderlichen Daten umfassen die geometrischen Eigenschaften des dritten Halbleiterchips 12, sowie die Anordnung des dritten Halbleiterchips 12 in bezug zu dem Gehäuse 7 und darüber hinaus die geometrischen und elektrischen Eigenschaften sowie die genaue Anordnung der Kontaktflächen 121 bis 124.

Im nächsten Verfahrensschritt 406 werden die geometrischen und elektrischen Eigenschaften des Gehäuses 7 sowie der auf der Oberseite des Gehäuses 7 angeordneten Kontaktanschlußflächen 721 bis 723 eingelesen. Dieser Verfahrensschritt greift dabei auf die im Verfahrensschritt 401 bzw. in den Verfahrensschritten 103, 203 und 303 eingelesenen Gehäuseeigenschaften zurück. Diese geometrischen und elektrischen Eigenschaften des Gehäuses können sich auch aus einem separaten Gehäuseentwicklungsprozeß ergeben, der auf dem in Figur 3 gezeigten Verfahren zur Bestimmung der Anordnung von Kontaktflächen aufbaut und daraus ein Gehäuse entwirft, dieses simuliert, daraus Kontaktvorlagen erstellt und diese in einem Standardgraphikformat ablegt.

Nun wird ein Bondplan aus den extrahierten Halbleiterchipdaten und aus den eingelesenen Gehäusedaten erstellt. Die Darstellung in Figur 8, bei der die Bondverbindungen zwischen den Kontaktflächen 121 bis 123 und den Kontaktanschlußflächen 721 bis 723 nicht gestrichelt, sondern durchgezogen dargestellt sind, entspricht einem solchen gegenüber realen elektrischen Bauteilen stark vereinfachten Bondplan. Die Darstellung des realitätsgetreuen Bondplanes 13 in Figur 10 gibt eine Vorstellung von der Komplexität der elektronischen Bauteile, auf die das erfindungsgemäße Verfahren angewendet werden kann.

Im nächsten Verfahrensschritt 408 wird der erzeugte Bondplan auf Veränderungen gegenüber dem zu Beginn des Verfahrens erzeugten Abbild des elektronischen Bauteils untersucht, insbesondere auf Verschiebungen, auf Löschungen, auf Zusammenfassungen und auf Vertauschungen der Kontaktflächen 121-124. Das Abbild des dritten elektronischen Bauteils 11 entspricht im vorliegenden Ausführungsbeispiel dem erstellten Bondplan. Es werden keinerlei Abweichungen bzw. Fehler festgestellt. Im letzten erfindungsgemäßen Verfahrensschritt 409 wird der so erstellte Bondplan gespeichert bzw. an die Bonding-Maschinen zur Produktion weitergeleitet.

Nachfolgend wird das erfindungsgemäße Verfahren zum Erzeugen von Geometriedaten gemäß dem fünften Ablaufdiagramm in Figur 5 anhand des dritten elektronischen Bauteils 11 mit bezug auf die Figuren 8 und 9 erläutert.

Bis zu dem Verfahrensschritt 504 des Überprüfens des elektrischen und logischen Verhaltens des Halbleiterchips unter Verwendung von gängigen Simulations- und Verifikationsverfahren entspricht dabei das Verfahren zum Erzeugen von Geometriedaten dem gerade beschriebenen Verfahren zum Erstellen eines Bondplanes. Dementsprechend werden die Verfahrensschritte 501-504 nicht noch einmal erläutert.

Aus dem im Verfahrensschritt 503 bestimmten Abbild der aktiven Oberseite 81 des dritten Halbleiterchips 12 werden nun die für die Photomasken erforderlichen Geometriedaten bestimmt. Dabei werden Produktionstoleranzen einberechnet. Der Datenumfang dieser Geometriedaten beträgt bis zu einige Hundert Gigabyte und ist graphisch kaum darstellbar. Durch diese Geometriedaten wird der Aufbau mehrerer bzw. sämtlicher Photomasken eines für die Produktion eines Halbleiterchips notwendigen Maskensatzes bestimmt. Der Aufbau solcher Photomasken sowie die für solche Photomasken erforderlichen Geometriedaten sind dem Fachmann geläufig und werden an dieser Stelle nicht näher erläutert.

Die so erzeugten Geometriedaten werden auf Veränderungen gegenüber dem in Verfahrensschritt 501 bzw. im Verfahrensschritt 305 des zuvor ausgeführten Verfahrens erzeugten Abbild des dritten elektronischen Bauteils 12 untersucht. Im vorliegenden Ausführungsbeispiel werden keinerlei Verschiebungen, Löschungen, Zusammenfassungen oder Vertauschungen der Kontaktflächen 121-124 festgestellt. Daher werden die erzeugten Geometriedaten den nachfolgenden Prozessen zur manuellen Erstellung der Photomasken zur Verfügung gestellt.

## Patentansprüche

1. Verfahren zum Bestimmen der Anordnung von Kontaktflächen auf der aktiven Oberseite eines in oder auf einem Gehäuse angeordneten Halbleiterchips, wobei das Verfahren auf einem Computersystem ausgeführt wird und das die folgenden Schritte aufweist:
a) Einlesen von Halbleiterchipdaten, die geometrische Eigenschaften des Halbleiterchips (8; 10; 12) sowie Informationen über die Anzahl der an jedem Rand des Halbleiterchips (8; 10; 12) anzuordnenden Kontaktflächen (811-813; 101-103; 121-123) aufweisen, in das Computersystem,
b) Einlesen von Kontaktflächendaten, die geometrische und elektrische Eigenschaften der auf der aktiven Oberseite (81) des Halbleiterchips (8; 10; 12) anzuordnenden Kontaktflächen (811-813; 101-103; 121-123) aufweisen, in das Computersystem,
c) Einlesen von Gehäusedaten, die geometrische und elektrische Eigenschaften des Gehäuses (7) sowie der auf der Oberseite des Gehäuses (7) angeordneten Kontaktanschlußflächen (721-723) aufweisen, in das Computersystem,
d) Einlesen von Fertigungsdaten, welche die Anordnung des Halbleiterchips (8; 10; 12) in Bezug zu dem Gehäuse (7) festlegen, in das Computersystem,
e) Erzeugen eines Abbilds eines elektronischen Bauteils (6; 9; 11), welches das Gehäuse (7) und den mit seiner passiven Rückseite auf der Oberseite des Gehäuses (7) angeordneten Halbleiterchip (8; 10; 12) umfaßt, aus den in den Schritten a) bis d) eingelesenen Daten,
f) Anordnen der Kontaktflächen (811-813; 101-103; 121-123) in dem Abbild des elektronischen Bauteils (6; 9; 11) in Randbereichen auf der aktiven Oberseite (81) des Halbleiterchips (8; 10; 12) derart,
- daß die Kontaktflächen (811-813) jeweils auf geraden Verbindungslinien zwischen den Kontaktanschlußflächen (721-723) innerhalb des Gehäuses (7) und dem Flächenschwerpunkt (82) der aktiven Oberseite (81) des Halbleiterchips (8) liegen, oder
- daß die Kontaktflächen (811-813) zunächst jeweils auf Verbindungslinien zwischen den Kontaktanschlußflächen (721-723) auf der Oberseite des Gehäuses (7) und dem Flächenschwerpunkt (81) der aktiven Oberseite (81) des Halbleiterchips (8) angeordnet werden und daß die an einem gleichen Halbleiterchiprand angeordneten Kontaktflächen (101-103) anschließend so verschoben werden, daß die Abstände (d) zwischen benachbarten Kontaktflächen (101-103) und/oder zwischen den jeweils äußersten Kontaktflächen (101, 103) pro Halbleiterchiprand und den angrenzenden Halbleiterchiprändern jeweils gleich groß ausgebildet sind, oder
- daß die Abstände zwischen den jeweils miteinander elektrisch zu verbindenden Kontaktflächen (121-123) und Kontaktanschlußflächen (721-723) minimiert werden,
g) Bereitstellen der Kontaktflächenanordnungsdaten, die Informationen über die in Schritt f) bestimmte Anordnung der Kontaktflächen (811-813; 101-103; 121-123) auf der aktiven Oberseite (81) des Halbleiterchips (8; 10; 12) aufweisen, für nachfolgende Herstellungs- und/oder Entwurfsprozesse des Halbleiterchips (8; 10; 12) und/oder des Gehäuses (7) und/oder des elektronischen Bauteils (7; 9; 11).

2. Verfahren zum Erstellen eines Bondplanes für ein elektronisches Bauteil mit einem Halbleiterchip und mit einem Gehäuse, das auf einem Computersystem ausgeführt wird und die folgenden Schritte aufweist:
a) Bestimmen der Anordnung von Kontaktflächen (121-123) auf der aktiven Oberseite (81) des Halbleiterchips (12) durch Ausführen des Verfahrens nach Anspruch 1,
b) Bestimmen der Anordnung von integrierten Schaltungen (CPU, RAM, FLASH, EEPROM) auf der aktiven Oberseite (81) des Halbleiterchips (8; 10; 12) und/oder von Füllstrukturen (131-133), welche die elektrische Verbindung zwischen den Kontaktflächen (121-123) sicherstellen und am Rand der aktiven Oberseite (81) des Halbleiterchips (12) jeweils zwischen den Kontaktflächen (121-123) angeordnet sind,
c) Bestimmen eines Abbilds der aktiven Oberseite (81) des Halbleiterchips (12), wobei die Halbleiterbauelemente der in Schritt b) bestimmten integrierten Schaltungen (CPU, RAM, FLASH, EEPROM) in dem Abbild auf Gatterebene definiert, plaziert und verdrahtet werden und wobei das Abbild mehrere über- und nebeneinander angeordnete Ebenen aufweist,
d) Überprüfen des elektrischen und des logischen Verhaltens des Halbleiterchips (12) auf Basis des in Schritt c) bestimmten Abbilds unter Verwendung von Simulations- und Verifikationsverfahren,
e) Extrahieren der für den Bondplan erforderlichen Daten aus dem in Schritt c) bestimmten Abbild,
f) Einlesen von Gehäusedaten, die geometrische und/oder elektrische Eigenschaften des Gehäuses (7) sowie der auf der Oberseite des Gehäuses (7) angeordneten Kontaktanschlußflächen (721-723) aufweisen, in das Computersystem,
g) Erstellen eines Bondplanes auf der Basis der in Schritt e) extrahierten Daten und auf der Basis der in Schritt f) eingelesenen Gehäusedaten, wobei der Bondplan ein Abbild des Gehäuses (7) und des in bzw. auf dem Gehäuse (7) angeordneten Halbleiterchips (12) sowie eine Darstellung der Bondverbindungen zwischen den Kontaktflächen (121-123) und den Kontaktanschlußflächen (721-723) beinhaltet,
h) Überprüfen des in Schritt g) erstellten Bondplanes auf Veränderungen gegenüber dem in Schritt a) erzeugten Abbild des elektronischen Bauteils, insbesondere auf Löschungen, auf Zusammenfassungen und auf Vertauschungen der Kontaktflächen (121-123),
i) Bereitstellen des Bondplanes für die Bonding Maschinen.

3. Verfahren zum Erzeugen von Geometriedaten für die Erstellung von Fotomasken für die Belichtung eines elektronisches Bauteils mit einem Halbleiterchip und mit einem Gehäuse mittels photolithographischer Verfahren, wobei das Verfahren auf einem Computersystem ausgeführt wird und die folgenden Schritte aufweist:
a) Bestimmen der Anordnung von Kontaktflächen (121-123) auf der aktiven Oberseite (81) des Halbleiterchips (12) durch Ausführen des Verfahrens nach Anspruch 1,
b) Bestimmen der Anordnung von integrierten Schaltungen (CPU, RAM, FLASH, EEPROM) auf der aktiven Oberseite (81) des Halbleiterchips (8; 10; 12) und/oder von Füllstrukturen (131-133), welche die elektrische Verbindung zwischen den Kontaktflächen (121-123) sicherstellen und am Rand der aktiven Oberseite (81) des Halbleiterchips (12) jeweils zwischen den Kontaktflächen (121-123) angeordnet sind,
c) Bestimmen eines Abbilds der aktiven Oberseite (81) des Halbleiterchips (12), wobei die Halbleiterbauelemente der in Schritt b) bestimmten integrierten Schaltungen (CPU, RAM, FLASH, EEPROM) in dem Abbild auf Gatterebene definiert, plaziert und verdrahtet werden und wobei das Abbild mehrere über- und nebeneinander angeordnete Ebenen aufweist,
d) Überprüfen des elektrischen und des logischen Verhaltens des Halbleiterchips (12) auf Basis des in Schritt c) bestimmten Abbilds unter Verwendung von Simulations- und Verifikationsverfahren,
e) Bestimmen der für die Fotomasken erforderlichen Geometriedaten aus dem in Schritt c) bestimmten Abbild der aktiven Oberseite (81) des Halbleiterchips (12) unter Einberechnung von Produktionstoleranzen,
f) Überprüfen der in Schritt e) erzeugten Geometriedaten auf Veränderungen gegenüber dem in Schritt a) erzeugten Abbild des elektronischen Bauteils (11), insbesondere auf Verschiebungen, auf Löschungen, auf Zusammenfassungen und auf Vertauschungen der Kontaktflächen (121-123),
g) Bereitstellen der erzeugten Geometriedaten für die nachfolgende Erstellung der Fotomasken.

4. Verfahren nach einem der Ansprüche 1 bis 3, das zusätzlich den Schritt des Herstellens eines Halbleiterchips enthält.

5. Verfahren nach einem der Ansprüche 1 bis 4, das zusätzlich den Schritt des Herstellens eines Gehäuses für einen Halbleiterchip enthält.

6. Computerprogrammprodukt sowie Computerprogramm zum Ausführen eines Verfahrens zum Bestimmen der Anordnung von Kontaktflächen auf der aktiven Oberseite eines Halbleiterchips, das so ausgebildet ist, daß ein Verfahren gemäß Anspruch 1 ausführbar ist.

7. Computerprogrammprodukt sowie Computerprogramm zum Ausführen eines Verfahrens zum Erstellen eines Bondplanes für ein elektronisches Bauteil mit einem Halbleiterchip und mit einem Gehäuse, das so ausgebildet ist, daß ein Verfahren gemäß Anspruch 2 ausführbar ist.

8. Computerprogrammprodukt sowie Computerprogramm zum Ausführen eines Verfahrens zum Erzeugen von Geometriedaten für die Erstellung von Fotomasken für die Belichtung eines elektronisches Bauteils mit einem Halbleiterchip und mit einem Gehäuse mittels photolithographischer Verfahren, wobei das Verfahren so ausgebildet ist, daß ein Verfahren gemäß Anspruch 3 ausführbar ist.

9. Computerprogramm nach einem der Ansprüche 6 bis 8, das auf einem Speichermedium oder in einem Computerspeicher, insbesondere in einem Direktzugriffsspeicher abgespeichert ist.

10. Computerprogramm nach einem der Ansprüche 6 bis 8, das auf einem elektrischen Trägersignal übertragen wird.

11. Datenträger mit einem Computerprogramm nach einem der Ansprüche 6 bis 8.

## Claims

1. A method for determining the arrangement of contact areas on the active top side of a semiconductor chip arranged in or on a housing, the method being performed on a computer system and having the following steps of:
a) reading semiconductor chip data into the computer system, the semiconductor chip data comprising geometrical properties of the semiconductor chip (8; 10; 12) and also information about the number of contact areas (811-813; 101-103; 121-123) to be arranged at each edge of the semiconductor chip (8; 10; 12),
b) reading contact area data into the computer system, the contact area data comprising geometrical and electrical properties of the contact areas (811-813; 101-103; 121-123) to be arranged on the active top side (81) of the semiconductor chip (8; 10; 12),
c) reading housing data into the computer system, the housing data comprising geometrical and electrical properties of the housing (7) and also of the contact pads (721-723) arranged on the top side of the housing (7),
d) reading production data into the computer system, the production data defining the arrangement of the semiconductor chip (8; 10; 12) in relation to the housing (7),
e) generating a model of an electronic device (6; 9; 11), which comprises the housing (7) and the semiconductor chip (8; 10; 12) arranged with its passive rear side on the top side of the housing (7), from the data read in in steps a) to d),
f) arranging the contact areas (811-813; 101-103; 121-123) in the model of the electronic device (6; 9; 11) in edge regions on the active top side (81) of the semiconductor chip (8; 10; 12) in such a way
- that the contact areas (811-813) in each case lie on straight connecting lines between the contact pads (721-723) within the housing (7) and the area centroid (82) of the active top side (81) of the semiconductor chip (8), or
- that the contact areas (811-813) are firstly in each case arranged on connecting lines between the contact pads (721-723) on the top side of the housing (7) and the area centroid (82) of the active top side (81) of the semiconductor chip (8), and that the contact areas (101-103) arranged at an identical semiconductor chip edge are subsequently displaced such that the distances (d) between adjacent contact areas (101-103) and/or between the respective outermost contact areas (101, 103) per semiconductor chip edge and the adjoining semiconductor chip edges are formed with the same magnitude in each case, or
- that the distances between the contact areas (121-123) and contact pads (721-723) that are to be electrically connected to one another in each case are minimized,
g) providing the contact area arrangement data, which comprise information about the arrangement - determined in step f) - of the contact areas (811-813; 101-103; 121-123) on the active top side (81) of the semiconductor chip (8; 10; 12), for subsequent fabrication and/or design processes of the semiconductor chip (8; 10; 12) and/or of the housing (7) and/or of the electronic device (7; 9; 11).

2. A method for creating a bonding plan for an electronic device having a semiconductor chip and having a housing, which is performed on a computer system and has the following steps of:
a) determining the arrangement of contact areas (121-123) on the active top side (81) of the semiconductor chip (12) by performing the method as claimed in claim 1,
b) determining the arrangement of integrated circuits (CPU, RAM, FLASH, EEPROM) on the active top side (81) of the semiconductor chip (8; 10; 12) and/or of filler structures (131-133), which ensure the electrical connection between the contact areas (121-123) and are arranged at the edge of the active top side (81) of the semiconductor chip (12) in each case between the contact areas (121-123),
c) determining a model of the active top side (81) of the semiconductor chip (12), the semiconductor components of the integrated circuits (CPU, RAM, FLASH, EEPROM) determined in step b) being defined, positioned and wired in the model at the gate level, and the model having a plurality of levels arranged above and next to one another,
d) checking the electrical and the logical behavior of the semiconductor chip (12) on the basis of the model determined in step c) using simulation and verification methods,
e) extracting the data required for the bonding plan from the model determined in step c),
f) reading in housing data, which comprise geometrical and/or electrical properties of the housing (7) and also of the contact pads (721-723) arranged on the top side of the housing (7), into the computer system,
g) creating a bonding plan on the basis of the data extracted in step e) and on the basis of the housing data read in in step f), the bonding plan comprising a model of the housing (7) and of the semiconductor chip (12) arranged in or on the housing (7) and also a representation of the bonding connections between the contact areas (121-123) and the contact pads (721-723),
h) checking the bonding plan created in step g) for alterations with respect to the model of the electronic device generated in step a), in particular for deletions, for combinations and for interchangings of the contact areas (121-123),
i) providing the bonding plan for the bonding machines.

3. A method for generating geometry data for the creation of photomasks for the exposure of an electronic device having a semiconductor chip and having a housing by means of photolithographic methods, the method being performed on a computer system and having the following steps of:
a) determining the arrangement of contact areas (121-123) on the active top side (81) of the semiconductor chip (12) by performing the method as claimed in claim 1,
b) determining the arrangement of integrated circuits (CPU, RAM, FLASH, EEPROM) on the active top side (81) of the semiconductor chip (8; 10; 12) and/or of filler structures (131-133), which ensure the electrical connection between the contact areas (121-123) and are arranged at the edge of the active top side (81) of the semiconductor chip (12) in each case between the contact areas (121-123),
c) determining a model of the active top side (81) of the semiconductor chip (12), the semiconductor components of the integrated circuits (CPU, RAM, FLASH, EEPROM) determined in step b) being defined, positioned and wired at the gate level in the model, and the model having a plurality of levels arranged above and next to one another,
d) checking the electrical and the logical behavior of the semiconductor chip (12) on the basis of the model determined in step c) using simulation and verification methods,
e) determining the geometry data required for the photomasks from the model of the active top side (81) of the semiconductor chip (12) determined in step c), with production tolerances being included in the calculation,
f) checking the geometry data generated in step e) for alterations with respect to the model of the electronic device (11) generated in step a), in particular for displacements, for deletions, for combinations and for interchangings of the contact areas (121-123),
g) providing the geometry data generated for the subsequent creation of the photomasks.

4. The method as claimed in one of claims 1 to 3, the method comprising additionally the step of the production of a semiconductor chip.

5. The method as claimed in one of claims 1 to 4, the method comprising additionally the step of the production of a housing for a semiconductor chip.

6. A computer program product and a computer program for performing a method for determining the arrangement of contact areas on the active top side of a semiconductor chip, which is configured such that a method as claimed in claim 1 can be performed.

7. A computer program product and a computer program for performing a method for creating a bonding plan for an electronic device having a semiconductor chip and having a housing, which is configured such that a method as claimed in claim 2 can be performed.

8. A computer program product and a computer program for performing a method for generating geometry data for the creation of photomasks for the exposure of an electronic device having a semiconductor chip and having a housing by means of photolithographic methods, configured such that a method as claimed in claim 3 can be performed.

9. The computer program as claimed in one of claims 6 to 8, which is stored on a storage medium or in a computer memory, in particular in a random access memory.

10. The computer program as claimed in one of claims 6 to 8, which is transmitted on an electrical carrier signal.

11. A data carrier having a computer program as claimed in one of claims 6 to 8.

## Revendications

1. Procédé pour déterminer la disposition de surfaces de contact sur le côté supérieur actif d'une puce à semiconducteur disposée dans ou sur un boîtier, le procédé étant mis en oeuvre sur un système informatique et comprenant les étapes suivantes :
a) Chargement dans le système informatique de données relatives à la puce à semiconducteur qui présentent des propriétés géométriques de la puce à semiconducteur (8 ; 10 ; 12) ainsi que des informations sur le nombre de surfaces de contact (811-813 ; 101-103 ; 121-123) à disposer sur chaque bord de la puce à semiconducteur (8 ; 10 ; 12),
b) Chargement dans le système informatique de données relatives aux surfaces de contact qui présentent des propriétés géométriques et électriques des surfaces de contact (811-813 ; 101-103 ; 121-123) à disposer sur le côté supérieur actif (81) de la puce à semiconducteur (8 ; 10 ; 12),
c) Chargement dans le système informatique de données de boîtier qui présentent des propriétés géométriques et électriques du boîtier (7) ainsi que des surfaces de raccordement de contact (721-723) disposées sur le côté supérieur du boîtier (7),
d) Chargement dans le système informatique de données de fabrication qui déterminent la disposition de la puce à semiconducteur (8 ; 10 ; 12) par rapport au boîtier (7),
e) Génération à partir des données chargées aux étapes a) à d) d'une image d'un composant électronique (6 ; 9 ; 11) qui comprend le boîtier (7) et la puce à semiconducteur (8 ; 10 ; 12) disposée avec son côté dorsal passif sur le côté supérieur du boîtier (7),
f) Disposition des surfaces de contact (811-813 ; 101-103 ; 121-123) dans l'image du composant électronique (6 ; 9 ; 11) dans les zones de bordure sur le côté supérieur actif (81) de la puce à semiconducteur (8 ; 10 ; 12) de telle sorte
- que les surfaces de contact (811-813) se trouvent à chaque fois sur des lignes de liaison droites entre les surfaces de raccordement de contact (721-723) à l'intérieur du boîtier (7) et le barycentre de la surface (82) du côté supérieur actif (81) de la puce à semiconducteur (8) ou
- que les surfaces de contact (811-813) soient tout d'abord disposées à chaque fois sur des lignes de liaison entre les surfaces de raccordement de contact (721-723) sur le côté supérieur du boîtier (7) et le barycentre de la surface (82) du côté supérieur actif (81) de la puce à semiconducteur (8) et que les surfaces de contact (101-103) disposées sur un même bord de la puce à semiconducteur soient ensuite décalées de telle sorte que les écarts (d) entre les surfaces de contact (101-103) voisines et/ou entre les surfaces de contact (101, 103) respectivement les plus à l'extérieur par bord de la puce à semiconducteur et les bords adjacents de la puce à semiconducteur soient à chaque fois identiques ou
- que les écarts entre les surfaces de contact (121-123) et les surfaces de raccordement de contact (721-723) devant à chaque fois être reliées électriquement entre elles soient réduits,
g) Fourniture des données de disposition des surfaces de contact, lesquelles présentent les informations sur la disposition des surfaces de contact (811-813 ; 101-103 ; 121-123) déterminée dans l'étape f) sur le côté supérieur actif (81) de la puce à semiconducteur (8 ; 10 ; 12), pour les processus de fabrication et/ou de prototypage ultérieurs de la puce à semiconducteur (8 ; 10 ; 12) et/ou du boîtier (7) et/ou du composant électronique (7 ; 9 ; 11).

2. Procédé pour établir un plan de cablage par fil pour un composant électronique comprenant une puce à semiconducteur et comprenant un boîtier, lequel est mis en oeuvre sur un système informatique et présente les étapes suivantes :
a) Détermination de la disposition des surfaces de contact (121-123) sur le côté supérieur actif (81) de la puce à semiconducteur (12) en exécutant le procédé selon la revendication 1,
b) Détermination de la disposition de circuits intégrés (CPU, RAM, FLASH, EEPROM) sur le côté supérieur actif (81) de la puce à semiconducteur (8 ; 10 ; 12) et/ou des structures de remplissage (131-133) qui garantissent la liaison électrique entre les surfaces de contact (121-123) et qui sont disposées sur le bord du côté supérieur actif (81) de la puce à semiconducteur (12) à chaque fois entre les surfaces de contact (121-123),
c) Détermination d'une image du côté supérieur actif (81) de la puce à semiconducteur (12), les composants à semiconducteur des circuits intégrés (CPU, RAM, FLASH, EEPROM) déterminés à l'étape b) étant définis, placés et câblés dans l'image sur le plan de la grille et l'image présentant plusieurs plans disposés les uns au-dessus des autres et les uns à côté des autres,
d) Contrôle du comportement électrique et logique de la puce à semiconducteur (12) en se basant sur l'image déterminée à l'étape c) en utilisant des procédés de simulation et de vérification,
e) Extraction à partir de l'image déterminée à l'étape c) des données nécessaires pour le plan de cablage par fil,
f) Chargement dans le système informatique des données du boîtier, lesquelles présentent des propriétés géométriques et/ou électriques du boîtier (7) ainsi que des surfaces de raccordement de contact (721-723) disposées sur le côté supérieur du boîtier (7),
g) Établissement d'un plan de cablage par fil en se basant sur les données extraites à l'étape e) et en se basant sur les données de boîtier chargées à l'étape f), le plan de cablage par fil comportant une image du boîtier (7) et de la puce à semiconducteur (12) disposée dans ou sur le boîtier (7) ainsi qu'une représentation des liaisons par cablage par fil entre les surfaces de contact (121-123) et les surfaces de raccordement de contact (721-723),
h) Contrôle du plan de cablage par fil établi à l'étape g) pour y déceler d'éventuelles modifications par rapport à l'image du composant électronique générée à l'étape a), notamment des suppressions, des assemblages et des inversions des surfaces de contact (121-123),
i) Mise à disposition du plan de cablage par fil pour la machine de cablage par fil.

3. Procédé pour établir des données géométriques destinées à produire des photomasques pour l'insolation d'un composant électronique comprenant une puce à semiconducteur et comprenant un boîtier par un procédé photolithographique, le procédé étant mis en oeuvre sur un système informatique et présentant les étapes suivantes :
a) Détermination de la disposition des surfaces de contact (121-123) sur le côté supérieur actif (81) de la puce à semiconducteur (12) en exécutant le procédé selon la revendication 1,
b) Détermination de la disposition de circuits intégrés (CPU, RAM, FLASH, EEPROM) sur le côté supérieur actif (81) de la puce à semiconducteur (8 ; 10 ; 12) et/ou des structures de remplissage (131-133) qui garantissent la liaison électrique entre les surfaces de contact (121-123) et qui sont disposées sur le bord du côté supérieur actif (81) de la puce à semiconducteur (12) à chaque fois entre les surfaces de contact (121-123),
c) Détermination d'une image du côté supérieur actif (81) de la puce à semiconducteur (12), les composants à semiconducteur des circuits intégrés (CPU, RAM, FLASH, EEPROM) déterminés à l'étape b) étant définis, placés et câblés dans l'image sur le plan de la grille et l'image présentant plusieurs plans disposés les uns au-dessus des autres et les uns à côté des autres,
d) Contrôle du comportement électrique et logique de la puce à semiconducteur (12) en se basant sur l'image déterminée à l'étape c) en utilisant des procédés de simulation et de vérification,
e) Détermination des données géométriques nécessaires pour les photomasques à partir de l'image du côté supérieur actif (81) de la puce à semiconducteur (12) déterminée à l'étape c) en incluant les tolérances de production dans le calcul,
f) Contrôle des données géométriques générées à l'étape e) pour y déceler d'éventuelles modifications par rapport à l'image du composant électronique (11) générée à l'étape a), notamment des décalages, des suppressions, des assemblages et des inversions des surfaces de contact (121-123),
g) Mise à disposition des données géométriques générées pour la production ultérieure des photomasques.

4. Procédé selon l'une des revendications 1 à 3, qui contient en plus l'étape de fabrication d'une puce à semiconducteur.

5. Procédé selon l'une des revendications 1 à 4, qui contient en plus l'étape de fabrication d'un boîtier pour une puce à semiconducteur.

6. Produit logiciel informatique et programme informatique pour mettre en oeuvre un procédé de détermination de la disposition des surfaces de contact sur le côté supérieur actif d'une puce à semiconducteur, lequel est configuré de telle sorte qu'il permet de mettre en oeuvre un procédé selon la revendication 1.

7. Produit logiciel informatique et programme informatique pour mettre en oeuvre un procédé d'établissement d'un plan de cablage par fil pour un composant électronique comprenant une puce à semiconducteur et comprenant un boîtier, lequel est configuré de telle sorte qu'il permet de mettre en oeuvre un procédé selon la revendication 2.

8. Produit logiciel informatique et programme informatique pour mettre en oeuvre un procédé d'établissement des données géométriques destinées à produire des photomasques pour l'insolation d'un composant électronique comprenant une puce à semiconducteur et comprenant un boîtier par un procédé photolithographique, le procédé étant configuré de telle sorte qu'il permet de mettre en oeuvre un procédé selon la revendication 3.

9. Programme informatique selon l'une des revendications 6 à 8 qui est enregistré sur un support de mémorisation ou dans une mémoire d'ordinateur, notamment dans une mémoire à accès direct.

10. Programme informatique selon l'une des revendications 6 à 8 qui est transmis sur un signal porteur électrique.

11. Support de données comprenant un programme informatique selon l'une des revendications 6 à 8.
